# EUROPEAN PATENT SPECIFICATION

(11) **EP 1 763 140 B1**
(45) Date of publication and mention of the grant of the patent: **10.05.2017**
(21) Application number: 06016259.1
(22) Date of filing: 03.08.2006
(51) Int. Cl.: H03M 1/68

(54) **Capacitive digital to analog and analog to digital converters**
Kapazitiver Digital Analog Wandler und Analog Digital Wandler
Convertisseur numérique-analogique et convertisseur analogique-numérique capacitif

(30) Priority: 08.09.2005 US 715078 P; 05.12.2005 US 293917; 06.07.2006 US 481476; 06.07.2006 US 481477
(43) Date of publication of application: 14.03.2007
(73) Proprietor: Marvell World Trade Ltd., St. Michael 14027 (BB)
(72) Inventor: Sutardja, Sehat, Los Altos Hills, CA 94022 (US)
(74) Representative: Grünecker Patent- und Rechtsanwälte PartG mbB

(56) References cited:
- EP-A2- 0 282 034
- EP-A2- 0 286 138
- WO-A-00/62530
- WO-A-82/03955
- DE-A1- 3 033 914
- JP-A- 5 075 464
- JP-A- 9 214 344
- US-A- 4 200 863
- US-A- 5 561 426
- US-A- 6 154 162
- US-A1- 2003 234 736
- US-A1- 2005 078 026
- US-B1- 6 297 759
- RUNHUA SUN ET AL: "A pipelined A/D converter for high-speed and high-resolution application" ISCAS 2002. PROCEEDINGS OF THE 2002 IEEE INTERNATIONAL SYMPOSIUM ON CIRCUITS AND SYSTEMS. SCOTTSDALE, AZ, MAY 26 - 29, 2002, IEEE INTERNATIONAL SYMPOSIUM ON CIRCUITS AND SYSTEMS, NEW YORK, NY : IEEE, US, vol. VOL. 1 OF 5, 26 May 2002 (2002-05-26), pages I-917, XP002406058 ISBN: 0-7803-7448-7

## Description

### CROSS-REFERENCE TO RELATED APPLICATIONS.

This application claims the benefit of U.S. Provisional Application No. 60/715,078, filed on September 8, 2005.

### FIELD OF THE INVENTION

The present invention relates to digital to analog (D/A) and analog to digital (A/D) converters, and more particularly to capacitive and/or resistive D/A and A/D converters.

### BACKGROUND OF THE INVENTION

Digital to analog (D/A) converters can include arrays of capacitors that are selectively switched to convert a digital signal to an analog counterpart. However, mismatch between capacitors may cause the D/A converter to be non-monotonic. Monotonicity in a D/A converter means that as the digital input to the converter increases over a full-scale range, the analog output never exhibits a decrease between one conversion step and a subsequent conversion step. In other words, the slope of the transfer characteristic is never negative in a monotonic converter.

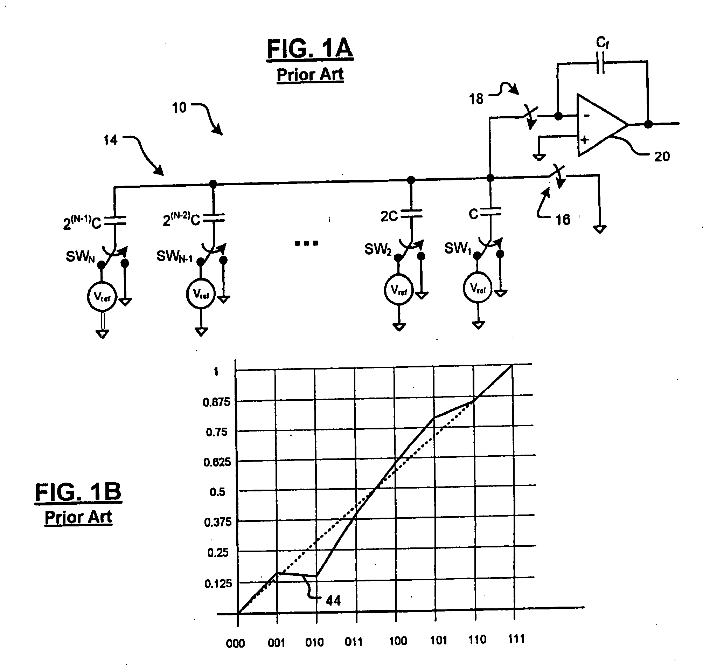

Referring now to FIG. 1A, a D/A converter 10 is shown. The D/A converter 10 includes a binary capacitor array 14, switches 16 and 18, an operational amplifier (opamp) 20, and a capacitor C_{f} in a feedback arrangement with the opamp 20. Each of the capacitors in the array 14 have different values. More particularly, each capacitor in the array 14 is twice the value of the preceding capacitor. Switches SW selectively switch the capacitors in the array 14 between a voltage reference and a reference potential such as ground.

In use, the D/A converter 10 has sampling and integration stages. In the sampling stage, the switch 16 closes and selective ones of the capacitors are charged to the voltage reference as determined by the switches. In the integrating phase, the switch 16 is opened and the analog output is generated. For example, a four bit array may close a first or most significant bit (MSB) switch and a least significant bit (LSB) switch to represent 9/16 of a voltage reference.

Referring now to FIG. 1B, a non-monotonic output of a D/A converter is shown. For example, the analog output exhibits a decrease from one conversion step to the subsequent conversion step as shown at in FIG. 1B at 44. The non-monotonic output may be due to capacitor mismatch. For example, the capacitor 2^{N-1}C may be different than 2^{N-2}C+2^{N-3}C + ... + 2C + C. Ideally, 2^{N-1}C - (2^{N-2}C+2^{N-3}C + ... + 2C +C) = C. In other words, the difference between the MSB capacitor and the rest of the capacitors should be equal to a smallest or LSB capacitor

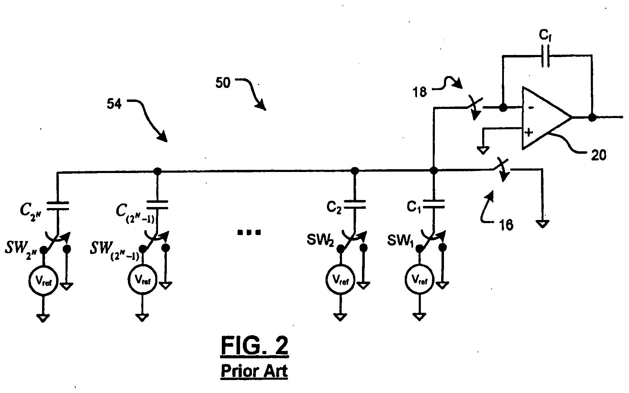

Referring now to FIG. 2, a D/A converter 50 including a linear capacitor array 54 is shown. The linear capacitor array 54 includes 2^{N}-1 capacitors that are selectively switched between a voltage reference and reference potential such as ground. While the linear capacitor array 54 inherently monotonic, the number of switches required grows exponentially with the bit resolution. For example, a 16-blt digital to analog converter includes 2¹⁶-1 pairs of switches, which may be impractical.

US 2005/0078026 A discloses a differential pipelined analog to digital converter with successive approximation register subconverter stages. In the system according to this document, two or more multi-bit successive approximation register (SAR) subconverter stages are cascaded to form a pipelined conversion system receiving an analog input and providing a digital output. According to this document, only two stages of cascaded capacitors are provided in the SAR stage.

From WO 82/03955 A1 a multiple function operational amplifier circuit is known which selectively performs a variety of circuit functions. A single operational amplifier utilizes switched capacitors for sampling and holding an input signal, for establishing a low frequency pole, for applying the sample to an output capacitance to charge the capacitance, and for comparing the input signal to a reference voltage. A companding DAC having a capacitor array is used as an output capacitance of the operational amplifier circuit. The DAC according to this document utilizes an R ladder DAC coupled directly to a C DAC. Coupled directly to the C DAC is an operational amplifier receive filter circuit which utilizes the C DAC as an input capacitor, such that the DAC can be used for both analog to digital and digital to analog conversion.

US 4,638,303 discloses a digital-to-analog converter, wherein a reference voltage is divided by a first string-like resistor array, whose two adjacent outputs are selected by a first switch array depending on the contents of upper bits of a digital signal and applied to the both ends of a second string-like resistance array. One of the switches in a second switch array is selectively turned on responsive to the contents of lower bits of the digital signal to pick out one of the divided voltages of the second resistor array. When referring to figure 10 of this document, the DAC converter shows three resistance arrays and switch arrays (first, intermediate and second) wherein the first resistance array, which is correlated to the switch array that is controlled by the first decoder decoding the most significant bits is connected to the power supply. The switch array connected to the code converter decoding the lower bits, is directly connected to the output terminal 215.

JP 05-075464 discloses an analog-to-digital converter circuit comprising capacitive elements and switches that are connected between a reference voltage application terminal and ground. Capacitive elements are connected to the connecting points of these capacitive elements via the switches and ground. The switch for sampling and holding is connected to the other terminal of the capacitive elements via further switches.

US 2003/234736 A1 relates to an analog-to-digital converter that includes a capacitive type digital-to-analog conversion circuit. A capacitor array constitutes a plurality of capacitors for sampling an input potential and storing electric charge. Furthermore, a first resistor type digital-to-analog conversion circuit for generating a desired potential by means of potential division is provided. A second resistor type digital analog conversion circuit is provided for generating a desired potential by potential division, and a first signal path is provided for adding an output of the first resistor type D/A conversion circuit to an output of the capacitor type D/A conversion circuit by capacity coupling. According to this document, a second signal path is provided for adding an output of the second resistor type D/A conversion circuit to an output of the capacitor type D/A conversion circuit by capacity coupling and a comparing circuit determines whether an output potential of the capacitive type D/A conversion circuit is higher or lower than the input potential.

US 6,154,162 relates to a dual-stage switched-capacitor DAC with scrambled MSB's. A digital-to-analog converter (DAC) uses switched capacitors summed, to an op amp to generate the analog output voltage. Least-significant-bits (LSBs) of the digital input switch a reference voltage to binary-weighted capacitors. The most-significant-bits (MSBs) are thermometer-coded and switch the reference voltage to capacitors that have a same size, double the size of the maximum LSB's capacitor. The thermometer-coded MSB's are scrambled before switching the same-size capacitors so that the assignment of a digital input bit to a capacitor varies from sample to sample. Any variation in capacitances for the same-size capacitors is thus spread to different digital values so that errors do not occur consistently for the same digital values. The scrambler uses radix-2 butterflies to swap bit assignments and thus outputs an even number of signals to the capacitors. Since the thermometer code is an odd number of signals, an extra signal is present that is always driven high or low. Scrambling makes the location of the extra signal unknown. A dummy same-size capacitor is driven to an opposite voltage to compensate for the extra signal. The DAC is further divided into two stages, with the lower stage scaled down to the minimum capacitor size by a linking capacitor to the upper stage.

US 4,200,863 discloses a weighted capacitor AD converting topology. An array of binary weighted capacitors, an additional capacitor having a capacitance value equivalent to that of the least of the binary weighted capacitors, a voltage comparator, switches for interconnecting the capacitors with certain predetermined voltage levels and the comparator, and a sequencing circuit are included. One side of all of the capacitors is connected to one input terminal on the comparator and the other side has applied thereto the signal to be quantized. Switch sequencing combines divided portions of a reference voltage with the signal to be quantized for presentation to the input of the comparator which thereby provides a serial digit output connected to the sequencing circuit. In this fashion, a linear conversion between an analog and a digital signal is made by the sequencing circuit. A nonlinear converter between digital and analog signal presentation is also disclosed. Resolution of the coder/decoder is increased by providing a reference voltage generator capable of supplying stepped increments of the reference voltage to the capacitor array during the comparison process.

JP 9-214344 relates to an AD converting circuit and a DA converting circuit. In particular, concerning a sequential comparison type A/D converting circuit 1, a capacitance array consisting of a charge redistribution type D/A converting circuit 2 is composed of 2^{m} pieces of unit capacitance C. Besides, an output VRTT of a resistant potential divided D/A converting circuit 3 can be impressed through switch arrays SW0, SW1...SW2^{m-1} to respective capacitance C0, C1...C2^{m-1} of the capacitance array. Thus, since the output VRTT of the resistant potential divided D/A converting circuit 3 can be impressed to the capacitance array to be used for discriminating high-order bits, the linearity of differentiation can be prevented from getting adverse.

A digital-to-analog converter (DAC) comprises a capacitive DAC that comprises N first capacitances that are connected in parallel and that have first ends and second ends, wherein N is an integer greater than one, and N first switches that selectively connect a selected one of the second ends of the N first capacitances to a common node and non-selected ones of the second ends of the N first capacitances to one of a voltage potential and a reference potential. Capacitance values of the N first capacitances are substantially equal. A second DAC communicates with the common node.

A digital-to-analog converter (DAC) comprises first converting means for converting a digital signal to an analog signal and that comprises N first capacitance means for providing capacitance that are connected in parallel-and that have first ends and second ends, wherein N is an integer greater than one and N first switching means for selectively connecting one of the second ends of the N first capacitance means to a common node and others of the second ends to one of a voltage potential and a reference potential. Capacitance values of the N first capacitance means are substantially equal. Second converting means converts a digital signal to an analog signal and that communicates with the common node.

A method for providing a digital-to-analog converter (DAC) comprises connecting N first capacitances of a first capacitive DAC in parallel, wherein the N first capacitances have first ends and second ends, N is an integer greater than one, and capacitance values of the N first capacitances are substantially equal. The method includes selectively connecting a selected one of the second ends of the N first capacitances to a common node; selectively connecting others of the second ends to one of a voltage potential and a reference potential; and connecting a second DAC to the common node.

A pipelined analog-to-digital converter (ADC) comprises a first stage that receives an input voltage signal and that comprises an analog-to-digital converter (ADC) that includes an amplifier having an input and an output; N capacitances that are connected in parallel and that include first ends that selectively communicate with the input and second ends; N switches that selectively connect the second ends of the N capacitances to the voltage input during a first phase, one of the second ends of the N capacitances to the output of the amplifier during a second phase, and others of the second ends of the N capacitances to one of a voltage reference and a reference potential during the second phase. A second stage communicates with the output the amplifier.

In other features, the first phase is a sampling phase and the second phase is a residue amplification phase. When the input voltage is between zero and a first ratio of a first of the N capacitances divided by a sum of the N capacitances, the first of the N capacitances is connected to the output of the amplifier and others of the N capacitances are connected to the reference potential during the second phase. When the input voltage is between the first ratio and a second ratio of a sum of the first and a second of the N capacitances divided by a sum of the N capacitances, the first of the N capacitances is connected to the voltage reference, the second of the N capacitances is connected to the output of the amplifier and others of the N capacitances are connected to the reference potential during the second phase. When the input voltage is between the second ratio and a third ratio of a sum of the first, the second and a third of the N capacitances divided by a sum of the N capacitances, the first and the second of the N capacitances are connected to the voltage reference, the third of the N capacitances is connected to the output of the amplifier and others of the N capacitances are connected to the reference potential during the second phase.

A pipelined analog-to-digital converter (ADC) comprises first stage means for receiving an input voltage signal and that comprises converting means for converting signals that includes: amplifying means for amplifying and having an input and an output; N capacitance means for providing capacitance, that are connected in parallel and that include first ends that selectively communicate with the input and second ends; and N switching means for selectively connecting the second ends of the N capacitance means to the voltage input during a first phase, one of the second ends of the N capacitance means to the output of the amplifier during a second phase, and others of the second ends of the N capacitance means to one of a voltage reference and a reference potential during the second phase; and second stage means for communicating with the output of the amplifying means of the first stage means.

In other features, the first phase is a sampling phase and the second phase is a residue amplification phase. When the input voltage is between zero and a first ratio of a first of the N capacitances divided by a sum of the N capacitances, the N switching means connect the first of the N capacitances to the output of the amplifier and others of the N capacitances to the reference potential during the second phase. When the input voltage is between the first ratio and a second ratio of a sum of the first and a second of the N capacitances divided by a sum of the N capacitances, the N switching means connect the first of the N capacitances to the voltage reference, the second of the N capacitances to the output of the amplifier and others of the N capacitances to the reference potential during the second phase. When the input voltage is between the second ratio and a third ratio of a sum of the first, the second and a third of the N capacitances divided by a sum of the N capacitances, the N switching means connect the first and the second of the N capacitances to the voltage reference, the third of the N capacitances to the output of the amplifier and others of the N capacitances to the reference potential during the second phase.

A method for generating a residue voltage in a pipelined analog-to-digital converter (ADC) comprises providing first and second stages, wherein the first stage receives a voltage input and includes a capacitive ADC including N capacitances; selectively connecting the second ends of the N capacitances to the voltage input during a first phase; selectively connecting one of the second ends of the N capacitances to the output of the amplifier during a second phase; selectively connecting others of the second ends of the N capacitances to one of a voltage reference and a reference potential during the second phase; selectively connecting the first ends of the N capacitances to an amplifier input; and connecting an amplifier output to the second stage.

In other features, the first phase is a sampling phase and the second phase is a residue amplification phase. The method further comprises selectively connecting the first of the N capacitances to the output of the amplifier and others of the N capacitances to the reference potential during the second phase when the input voltage is between zero and a first ratio of a first of the N capacitances divided by a sum of the N capacitances. The method further comprises selectively connecting the first of the N capacitances to the voltage reference, the second of the N capacitances to the output of the amplifier and others of the N capacitances to the reference potential during the second phase when the input voltage is between the first ratio and a second ratio of a sum of the first and a second of the N capacitances divided by a sum of the N capacitances. The method further comprises selectively connecting the first and the second of the N capacitances to the voltage reference, the third of the N capacitances to the output of the amplifier and others of the N capacitances to the reference potential during the second phase when the input voltage is between the second ratio and a third ratio of a sum of the first, the second and a third of the N capacitances divided by a sum of the N capacitances.

A digital to analog converter (DAC) comprises X capacitive DACs that are connected in series and wherein X is an integer greater than one. Each of the X capacitive DACs comprise M switches wherein M is an integer greater than one; a signal input; a signal output; and M capacitances that communicate with the M switches, respectively, and that have first and second ends and substantially equal capacitance values. The M switches selectively connect the first ends of the M capacitances to the signal output. The M switches connect the second end of a selected one of the M capacitances to the signal input. A first DAC has a signal output that communicates with the signal input of one of the X capacitive DACs.

In other features, an amplifier has an input and an output. A feedback capacitance communicates with the input and the output of the amplifier. The first ends of the M capacitances of another one of the X DACs communicates with a reference potential during a first phase of the another one of the X DACs. The input of the amplifier selectively communicates with the first ends of the M capacitances of the another one of the X DACs during a second phase of the another one of the X DACs.

In other features, an amplifier has an input and an output. The first ends of the M capacitances of another one of the X DACs communicate with a reference potential during a first phase of the another one of the X DACs. The input of the amplifier selectively communicates with the first ends of the M capacitances of the another one of the X DACs during a second phase of the another one of the X DACs. The second ends of the of the M capacitances of the another one of the X DACs communicate with the output of the amplifier during the second phase of the another one of the X DACs. The first DAC comprises Y resistive DACs wherein Y is an integer greater than zero.

In other features, at least one of the Y resistive DACs comprises a signal output; N resistances connected in series between the voltage reference and the reference potential; N nodes between select ones of the N resistances and the reference potential; and N second switches that selectively connect the signal output of the one of the Y resistive DACs to one of the N nodes. A control module selectively generates switching signals to control the X capacitive DACs and the first DAC.

In other features, a successive approximation analog-to-digital converter comprises the DAC. The successive approximation analog-to-digital converter of comprises an amplifier having an input that selectively communicates with one of the X capacitive DACs. A successive approximation module communicates with an output of the amplifier. A decoding module communicates with an output of the successive approximation module and selectively generates switching signals for the X capacitive DACs and the first DAC.

In other features, the first DAC comprises a capacitive DAC. The capacitive DAC comprises a signal output and an amplifier having an input and an output that communicates with the signal output. M second capacitances are connected in parallel and have first ends and second ends. The first ends selectively communicate with a reference potential during a first phase of the capacitive DAC. The first ends selectively communicate with the input of the amplifier during a second phase of the capacitive DAC. M second switches selectively connect the second ends of the M second capacitances to one of the voltage reference and the reference potential during the first phase of the capacitive DAC and selectively connect the second ends of the M second capacitances to the output during the second phase of the capacitive DAC.

A digital to analog converter (DAC) comprises X capacitive converting means for converting a digital signal to an analog signal and that are connected together in series and wherein X is an integer greater than one. Each of the X capacitive converting means comprise M switching means for switching wherein M is an integer greater than one. M capacitance means for providing capacitance communicate with the M switching means, respectively, and have first and second ends and substantially equal capacitance values. The M switching means selectively connect the first ends of the M capacitance means to the signal output. The M switching means connect the second end of a selected one of the M capacitance means to the signal input. First converting means converts a digital signal to an analog signal and has a signal output that communicates with the signal input of one of the X capacitive converting means.

In other features, amplifying means for amplifying and has an input and an output. Feedback capacitance means provides capacitance and communicates with the input and the output of the amplifying means. The first ends of the M capacitance means of another one of the X converting means communicates with a reference potential during a first phase of the another one of the X converting means. The input of the amplifying means selectively communicates with the first ends of the M capacitance means of the another one of the X converting means during a second phase of the another one of the X converting means.

In other features, amplifying means for amplifying has an input and an output. The first ends of the M capacitance means of another one of the X converting means communicates with a reference potential during a first phase of the another one of the X converting means. The input of the amplifying means selectively communicates with the first ends of the M capacitance means of the another one of the X converting means during a second phase of the another one of the X converting means. The second ends of the M capacitance means of the another one of the X converting means communicate with the output of the amplifying means during the second phase of the another one of the X converting means. The first DAC comprises Y resistive converting means for converting a digital signal to an analog signal and wherein Y is an integer greater than zero.

In other features, at least one of the Y resistive converting means comprises a signal output and N resistance means for providing resistance and that is connected in series between the voltage reference and the reference potential. N nodes are located between select ones of the N resistance means and the reference potential. N second switching means selectively connect the signal output of the one of the Y resistive converting means to one of the N nodes. Control means selectively generates switching signals to control the X capacitive converting means and the first DAC.

In other features, a successive approximation analog-to-digital converter comprises the DAC. The successive approximation analog-to-digital converter comprises amplifying means for amplifying and having an input that selectively communicates with one of the X capacitive DACs and approximation means for successive approximating and that communicates with an output of the amplifying means. Decoding means communicates with an output of the successive approximation module for selectively generating switching signals for the X capacitive DACs and the first DAC.

In other features, the first DAC comprises a capacitive converting means for converting a digital signal to an analog signal. The capacitive converting means comprises a signal output and amplifying means for amplifying and having an input and an output that communicates with the signal output. M second capacitance means provides capacitance and is connected in parallel and has first ends and second ends. The first ends selectively communicate with a reference potential during a first phase of the capacitive DAC. The first ends selectively communicate with the input of the amplifying means during a second phase of the capacitive DAC. M second switching means selectively connect the second ends of the M second capacitance means to one of the voltage reference and the reference potential during the first phase of the capacitive DAC and selectively connect the second ends of the M second capacitance means to the output during the second phase of the capacitive DAC.

A method for operating a digital to analog converter (DAC) comprises connecting X capacitive DACs in series and wherein X is an integer greater than one, wherein each of the X capacitive DACs comprise M capacitances that have first and second ends and substantially equal capacitance values; selectively connecting the first ends of the M capacitances to the signal output; connecting the second end of a selected one of the M capacitances to the signal input; and connecting a signal output of a first DAC to the signal input of one of the X capacitive DACs.

In other features, the method comprises providing an amplifier having an input and an output and a feedback capacitance that communicates with the input and the output of the amplifier. The method comprises connecting the first ends of the M capacitances of another one of the X DACs with a reference potential during a first phase of the another one of the X DACs. The method comprises selectively connecting the input of the amplifier to the first ends of the M capacitances of the another one of the X DACs during a second phase of the another one of the X DACs.

In other features, the method comprises providing an amplifier having an input and an output; selectively connecting the first ends of the M capacitances of another one of the X DACs with a reference potential during a first phase of the another one of the X DACs; selectively connecting the input of the amplifier with the first ends of the M capacitances of the another one of the X DACs during a second phase of the another one of the X DACs; and selectively connecting the second ends of the of the M capacitances of the another one of the X DACs communicate with the output of the amplifier during the second phase of the another one of the X DACs.

In other features, the first DAC comprises Y resistive DACs wherein Y is an integer greater than zero. The method comprises selectively generating switching signals to control the X capacitive DACs and the first DAC. The method comprises using the X capacitive DACs to successively approximate an analog input signal. The first DAC comprises a capacitive DAC.

Further areas of applicability of the present invention will become apparent from the detailed description provided hereinafter. It should be understood that the detailed description and specific examples, while indicating the preferred embodiment of the invention, are intended for purposes of illustration only and are not intended to limit the scope of the invention.

### BRIEF DESCRIPTION OF THE DRAWINGS

The present invention will become more fully understood from the detailed description and the accompanying drawings, wherein:
FIG. 1A is an electrical schematic of a binary capacitor array D/A converter according to the prior art;
FIG. 1B is a graph of a D/A converter;
FIG. 2 is an electrical schematic of a linear capacitor array D/A converter according to a prior art;
FIGs. 3A-3B are electrical schematics of a capacitive-resistive D/A converter in exemplary configurations; Fig. 3C is a comparative example not part of the invention;
FIG. 4A illustrates the D/A converter of FIG. 3B during a sampling phase for a first digital value;
FIG. 4B illustrates the D/A converter of FIG. 3B during an integrating phase for a first digital value;
FIG. 4C is an exemplary truth table for the circuit of FIG. 3B;
FIG. 4D is an exemplary truth table for the circuit of FIG. 3C;
FIG. 5 illustrates the D/A converter of FIG. 3B during a sampling phase for a second digital value;
FIG. 6 illustrates the D/A converter of FIG. 3B during a sampling phase for a third digital value;
FIG. 7 illustrates the D/A converter of FIG. 3B during a sampling phase for a fourth digital value;
FIG. 8A is an electrical schematic of a capacitive-capacitive D/A converter;
FIG. 8B is an electrical schematic of a capacitive-capacitive D/A converter in a sample and integrate configuration;
FIG. 8C illustrates the D/A converter of FIG. 8B during a sampling phase for a first digital value;
FIG. 8D illustrates the D/A converter of FIG. 8B during an integrating phase for a first digital value;
FIG. 8E illustrates the D/A converter of FIG. 8B during a sampling phase for a second digital value;
FIG. 8F illustrates the D/A converter of FIG. 8B during a sampling phase for a third digital value;
FIG. 8G illustrates the D/A converter of FIG. 8B during a sampling phase for a fourth digital value;
FIG. 8H is an exemplary timing diagram showing sampling and integrating phases for LSB and MSB portions;
FIG. 8I is an exemplary timing diagram showing sampling and integrating phases for LSB and MSB portions;
FIG. 8J is an exemplary truth table for the D/A converter of FIG. 8B;
FIG. 9A illustrates an N-stage capacitive D/A converter;
FIG. 9B illustrates an N-stage capacitive-resistive D/A converter;
FIG. 9C is an exemplary timing diagram showing non-overlapping sampling and integrating phases for additional stages;
FIG. 9D is an exemplary timing diagram showing overlapping sampling and integrating phases for additional stages;
FIG. 10 is an electrical schematic of a successive approximation A/D converter;
FIG. 11A is an electrical schematic of a pipelined A/D converter according to a comparative example not part of the invention;
FIG. 11B-11D illustrate ideal and non-ideal residue voltages;
FIG. 12A illustrates an A/D converter that generates an ideal residue voltage according to the present invention;
FIG. 12B illustrates the A/D converter of FIG. 12A in a sampling phase;
FIG. 12C illustrates the A/D converter of FIG. 12A in a residue amplification stage for a first voltage input value;
FIG. 12D is an exemplary truth table for the A/D converter of FIG. 12A;
FIG. 13 illustrates the A/D converter of FIG. 12A in a residue amplification stage for a second voltage input value;
FIG. 14 illustrates the A/D converter of FIG. 12A in a residue amplification stage for a third voltage input value;
FIG. 15 illustrates the A/D converter of FIG. 12A in a residue amplification stage for a fourth voltage input value;
FIG. 16 is a graph illustrating variable interstage gain and an ideal residue voltage of the circuit of FIG. 12A;
FIG. 17A is a functional block diagram of a hard disk drive;
FIG. 17B is a functional block diagram of a digital versatile disk (DVD);
FIG. 17C is a functional block diagram of a high definition television;
FIG. 17D is a functional block diagram of a vehicle control system;
FIG. 17E is a functional block diagram of a cellular phone;
FIG. 17F is a functional block diagram of a set top box; and
FIG. 17G is a functional block diagram of a media player.

### DETAILED DESCRIPTION OF THE PREFERRED EMBODIMENTS

The following description of the preferred embodiment(s) is merely exemplary in nature and is in no way intended to limit the invention, its application, or uses. For purposes of clarity, the same reference numbers will be used in the drawings to identify similar elements. As used herein, the term module, circuit and/or device refers to an Application Specific Integrated Circuit (ASIC), an electronic circuit, a processor (shared, dedicated, or group) and memory that execute one or more software or firmware programs, a combinational logic circuit, and/or other suitable components that provide the described functionality. As used herein, the phrase at least one of A, B, and C should be construed to mean a logical (A or B or C), using a non-exclusive logical or. It should be understood that steps within a method may be executed in different order without altering the principles of the present invention.

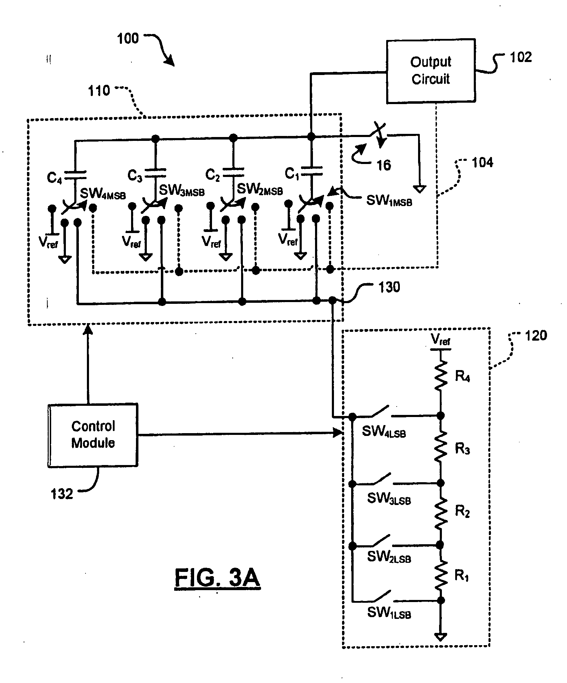

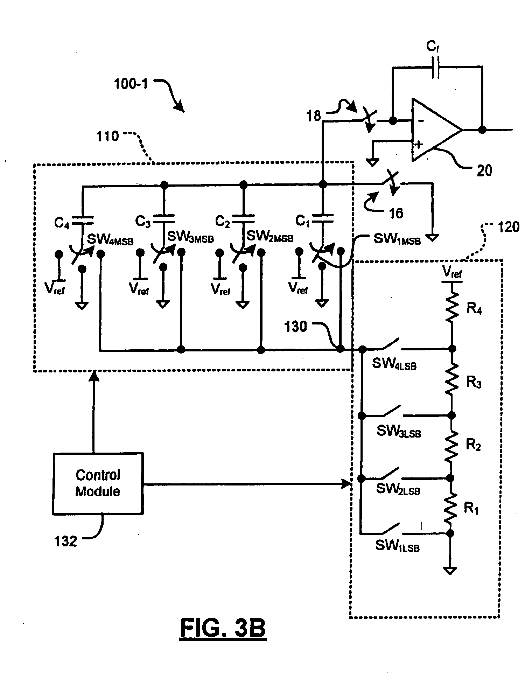

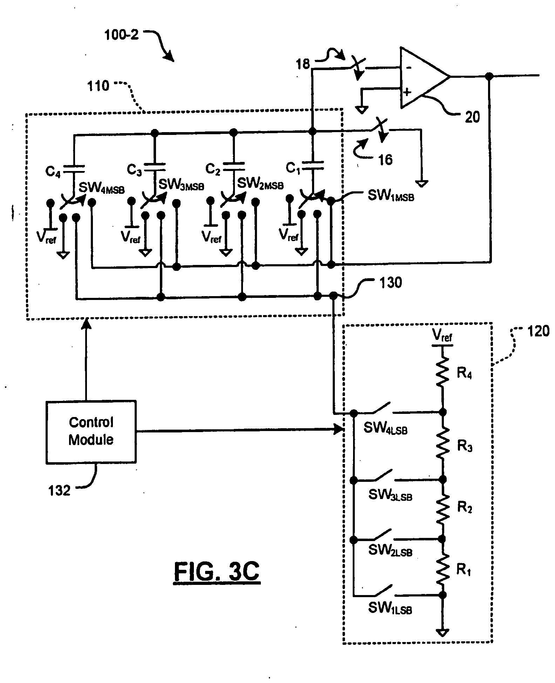

Referring now to FIG. 3A and 3B, capacitive-resistive D/A converters 100, 100-1 and 100-2 are shown. For simplicity, an N=4 bit example is shown in FIGs. 3A-3C. Skilled artisans will appreciate that N can be set to other numbers of bits. Various types of output circuits 102 may be used. Additional connections 104, which may or may not be switched connections, may be used depending upon the function that is desired. For example in FIG. 3B, the DAC 100-1 is shown in a sample and integrate configuration and in FIG. 3C, a DAC 100-2 is shown with a sample and hold configuration.

In this example, the two most significant bits (MSBs) are allocated to a capacitive portion 110 and the two least significant bits (LSBs) are allocated to a resistive portion 120. In the Figures that follow, the capacitor C_{f} will be shown with dotted lines to indicate both sample and hold and sample and integrate configurations.

The capacitive portion 110 includes capacitors C₁, C₂, C₃ and C₄. In the preferred embodiment, the capacitors C₁, C₂, C₃ and C₄ have a substantially equal capacitance value. The capacitors may have substantially the same capacitance value, in other words C₁= C₂ = C₃ = C₄. As will be described further below, the capacitors are selectively switched by switches SW_{4MSB}, SW_{3MSB}, SW_{2MSB}, and SW_{1MSB} (collectively switches SW_{M}) between a voltage reference V_{ref}, a reference potential such as ground, and a common node 130 between the resistive portion 120 and the capacitive portion 110.

The resistive portion 110 includes resistors R₁, R₂, R₃ and R₄. In the preferred embodiment, the resistors R₁, R₂, R₃ and R₄ have a substantially equal resistance value. The resistors may have the same resistance value, in other words R₁ = R₂ = R₃ = R₄. As will be described further below, the resistors are connected in series between V_{ref} and a reference potential such as ground. A node between the resistors is selected by switches SW_{4LSB}, SW_{3LSB}, SW_{2LSB}, and SW_{1LSB} (collectively switches SW_{L}) and connected to the common node 130 to create a voltage divider.

The sample and integrate circuit was described above. In the sample and hold configuration, the second ends of the capacitances C₁, C₂, C₃ and C₄ are switched to the output of the amplifier during the second phase of the capacitive portion 110. The feedback capacitance C_{f} may be omitted.

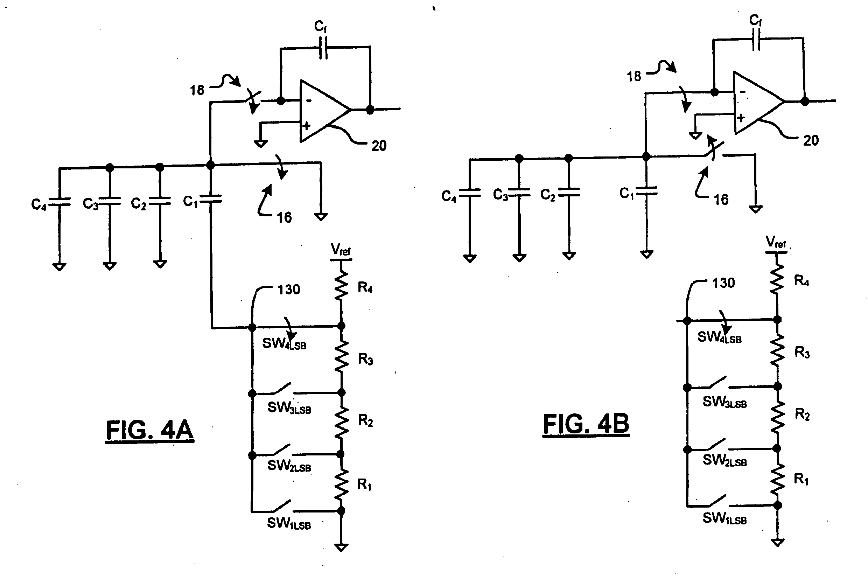

Referring now to FIG. 4A, the D/A converter of FIG. 3B is shown during a sampling phase for a first digital value (0011). Initially, the switch 16 is closed, the switch 18 is opened and the capacitors C₂, C₃ and C₄ are switched by respective switches to the reference potential, which may be ground. The capacitor C₁ is connected to the common node. The capacitive portion 110 will be in this configuration when the desired binary value is between 0000 and 0011. One of the resistive switches SW_{4LSB}, SW_{3LSB}, SW_{2LSB}, and SW_{1LSB} is closed to create a voltage divider. In the example shown in FIG. 4A, the switch SW_{4LSB} is closed to provide $\frac{3}{4} {V}_{ref} .$ A charge is accumulated on the capacitor C₁ that is equal to *V_{RDAC}C*₁, where *V_{RDAC}* is the voltage provided by the resistive portion 120.

Referring now to FIG. 4B, the D/A converter of FIG. 3B is shown during an integrating phase for the first digital value (0011). In this phase, the switch 16 is opened, the switch 18 is closed and the voltage value is applied to the amplifier 20. Using a charge equalization approach, the total charge before changing the position of the switches 16 and 18 is equal to the total charge after changing the position of the switches 16 and 18: ${Q}_{T} = {VC}_{f} = {V}_{RDAC} {C}_{1} ;$ $V = {V}_{RDAC} \frac{{C}_{1}}{{C}_{f}} .$ The value of C_{f} can be set equal to C₁, C₂, C₃ and C₄ or be used to scale the output voltage and not be equal to C₁, C₂, C₃ and C₄. In the example above, ${V}_{RDAC} = \frac{3}{4} {V}_{ref} .$ As can be appreciated, the value can also be adjusted to ${V}_{RDAC} = 0 , {V}_{RDAC} = \frac{1}{4} {V}_{ref} ,$ *or* ${V}_{RDAC} = \frac{1}{2} {V}_{ref}$ by selecting the switch SW_{1LSB}, SW_{2LSB} or SW_{3LSB}, respectively. Scaling can be performed by adjusting the value of C_{f} relative to C₁, C₂, C₃ and C₄. For example, if Cf = C₁ + C₂ + C₃ + C₄, then the output ranges 0 to near V_{ref} rather than 0 to near 4 V_{ref} in this example.

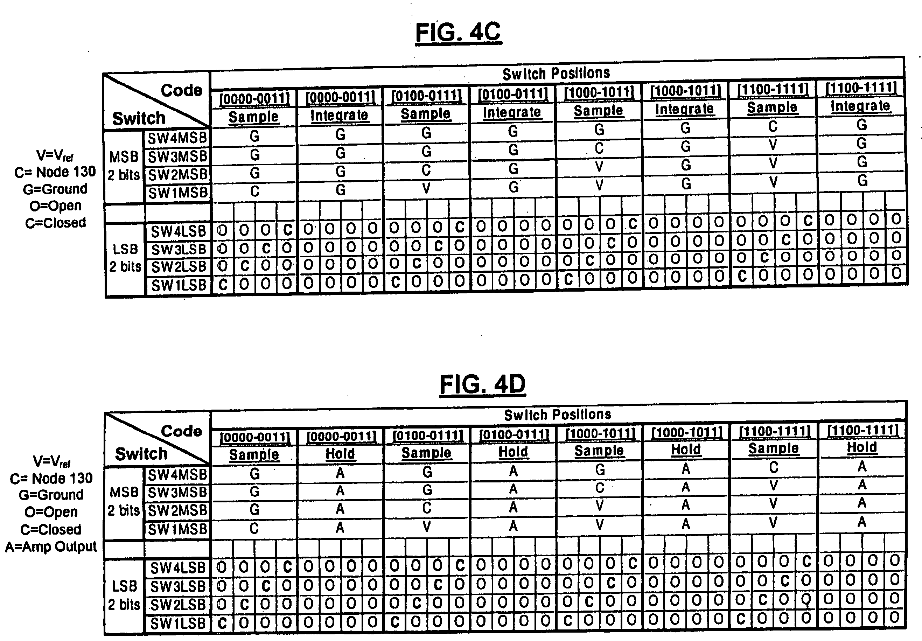

Referring now to FIG. 4C, a truth table for the exemplary converter of FIG. 3B is shown. In this example, C_{f} is equal to C₁, C₂, C₃ and C₄ although other values may be used for scaling. Referring now to FIG. 4D, a truth table for the exemplary converter of FIG. 3C is shown.

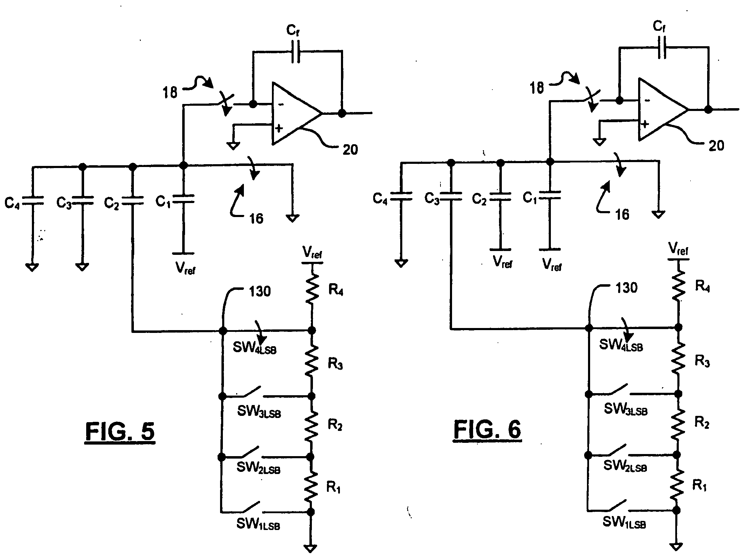

Referring now to FIG. 5, the D/A converter of FIG. 3B is shown during an integrating phase for a second digital value (0111). Initially, the switch 16 is closed, the switch 18 is opened and the capacitors C₃ and C₄ are switched by respective switches to the reference potential, which may be ground. The capacitor C₂ is connected to the common node 130 and the capacitor C₁ is connected to V_{ref}. The capacitive portion 110 will be in this configuration when the desired binary value is between 0100 and 0111. One of the resistive switches SW_{4LSB}, SW_{3LSB}, SW_{2LSB}, and SW_{1LSB} is closed to create a voltage divider. In the example shown in FIG. 5, the switch SW_{4LSB} is closed to provide $\frac{3}{4} {V}_{ref} .$ A charge is accumulated on the capacitor C₂ that is equal to *V_{RDAC}C*₂, where *V_{RDAC}* is the voltage provided by the resistive portion. A charge is also accumulated on capacitor C₁ equal to *V_{ref}C*₁.

During an integrating phase for the second digital value (0111). the switch 16 is opened, the switch 18 is closed and the voltage value is applied to the amplifier 20. Using a charge equalization approach, the total charge before changing the position of the switches 16 and 18 is equal to the total charge after changing the position of the switches 16 and 18: - ${Q}_{T} = {VC}_{f} = {V}_{RDAC} {C}_{2} + {V}_{ref} {C}_{1} ;$ $V = {V}_{RDAC} \frac{{C}_{2}}{{C}_{f}} + {V}_{ref} \frac{{C}_{1}}{{C}_{f}} .$ The value of C_{f} can be set equal to C₁, C₂, C₃ and C₄ or be used to scale the output voltage and not be equal to C₁, C₂, C₃ and C₄. If C_{f}, C₁ and C₂ are the same, *V* = *V_{RDAC}* + *V_{ref}.*

Referring now to FIG. 6, the D/A converter of FIG. 3B is shown during an integrating phase for a third digital value (1011). Initially, the switch 16 is closed, the switch 18 is opened and the capacitor C₄ is switched by a respective switch to the reference potential, which may be ground. The capacitor C₃ is connected to the common node 130 and the capacitors C₁ and C₂ are connected to V_{ref}. The capacitive portion 110 will be in this configuration when the desired binary value is between 1000 and 1011. One of the resistive switches SW_{4LSB}, SW_{3LSB}, SW_{2LSB}, and SW_{1LSB} is closed to create a voltage divider. In the example shown in FIG. 6, the switch SW_{4LSB} is closed to provide $\frac{3}{4} {V}_{ref} .$ A charge is accumulated on the capacitor C₃ that is equal to *V_{RDAC}C*₃, where *V_{RDAC}* is the voltage provided by the resistive portion. A charge is also accumulated on capacitors C₁ and C₂ that is equal to *V_{ref}*(*C*₁ + *C*₂).

During an integrating phase for the third digital value (1011). the switch 16 is opened, the switch 18 is closed and the voltage value is applied to the amplifier 20. Using a charge equalization approach, the total charge before changing the position of the switches 16 and 18 is equal to the total charge after changing the position of the switches 16 and 18: ${Q}_{r} = {VC}_{f} = {V}_{RDAC} {C}_{3} + {V}_{ref} \left({C}_{1}+{C}_{2}\right) ;$ $V = {V}_{RDAC} \frac{{C}_{3}}{{C}_{f}} + {V}_{ref} \frac{{C}_{1} + {C}_{2}}{{C}_{f}} .$ The value of C_{f} can be set equal to C₁, C₂, C₃ and C₄ or be used to scale the output voltage and not be equal to C₁, C₂, C₃ and C₄. If C_{f}, C₁, C₂ and C₃ are the same, *V* = *V_{RDAC}* + 2*V_{ref}.*

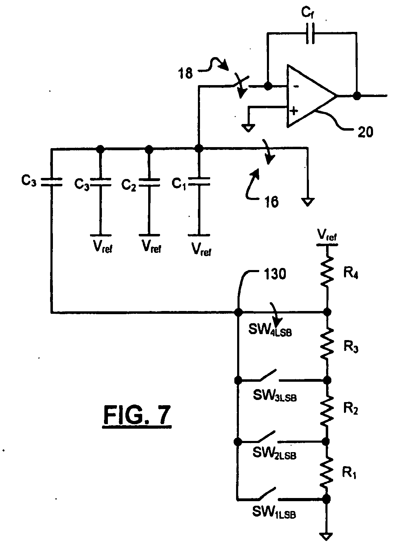

Referring now to FIG. 7, the D/A converter of FIG. 3B is shown during an integrating phase for a forth digital value (1111). Initially, the switch 16 is closed and the switch 18 is opened. The capacitor C₄ is connected to the common node 130 and the capacitors C₁, C₂ and C₃ are connected to V_{ref}. The capacitive portion 110 will be in this configuration when the desired binary value is between 1100 and 1111. One of the resistive switches SW_{4LSB}, SW_{3LSB}, SW_{2LSB}, and SW_{1LSB} is closed to create a voltage divider. In the example shown in FIG. 7, the switch SW_{4LSB} is closed to provide $\frac{3}{4} {V}_{ref} .$ A charge is accumulated on the capacitor C₄ that is equal to *V_{RDAC}C*₄, where *V_{RDAC}* is the voltage provided by the resistive portion. A charge is accumulated on capacitors C₁, C₂ and C₃ that is equal to *V_{ref}*(*C*₁ +*C*₂ + *C*₃).

During an integrating phase for the fourth digital value (1111). the switch 16 is opened, the switch 18 is closed and the voltage value is applied to the amplifier 20. Using a charge equalization approach, the total charge before changing the position of the switches 16 and 18 is equal to the total charge after changing the position of the switches 16 and 18: ${Q}_{T} = {VC}_{f} = {V}_{RDAC} {C}_{4} + {V}_{ref} \left({C}_{1}+{C}_{2}+{C}_{3}\right) ;$ $V = {V}_{RDAC} \frac{{C}_{4}}{{C}_{f}} + {V}_{ref} \frac{{C}_{1} + {C}_{2} + {C}_{3}}{{C}_{f}} .$ The value of C_{f} can be set equal to C₁, C₂, C₃ and C₄ or be used to scale the output voltage and not be equal to C₁, C₂, C₃ and C₄. If C_{f}, C₁, C₂, C₃ and C₄ are the same, *V* = V*_{RDAC}* + 3*V_{ref}.*

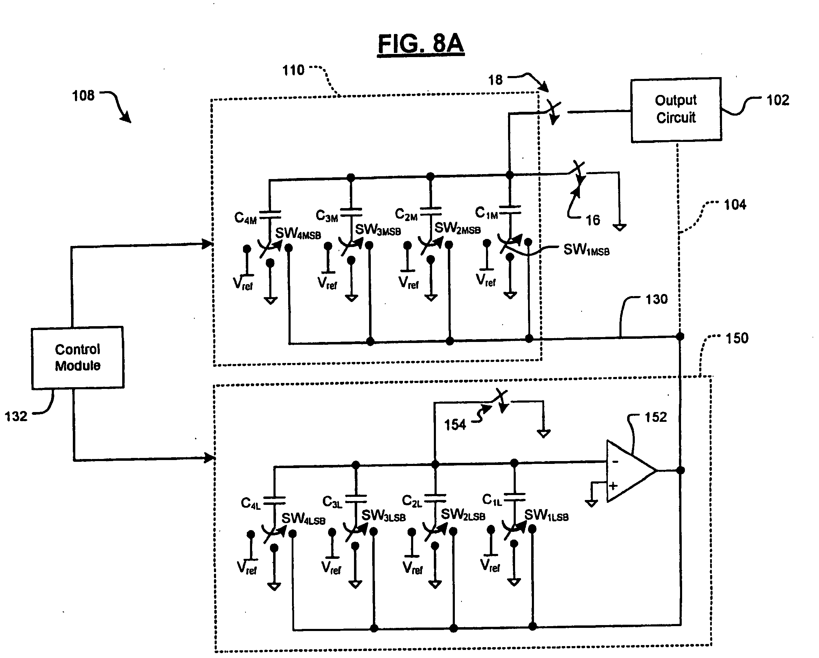

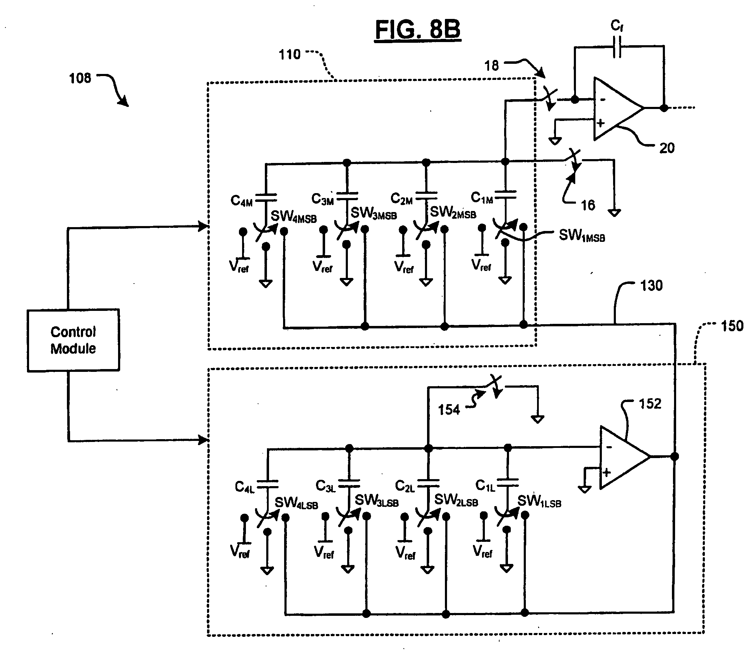

Referring now to FIG. 8A and 8B, a nested segmented capacitive-capacitive D/A converter 108 according to the present invention is shown. In FIG. 8A, the output circuit 102 is shown. In FIG. 8B, an exemplary sample and integrate configuration is shown. The capacitive portion 110 operates as described above. For purposes of clarity, the capacitors C₁, C₂, C₃ and C₄ have been relabeled C_{1M}, C_{2M}, C_{3M} and C_{4M}. A second capacitive portion 150 is associated with the two least significant bits and includes capacitors C_{1L}, C_{2L}, C_{3L} and C_{4L}. The voltage provided by the LSB capacitive portion 150 is V_{CDAC}. The second capacitive portion 150 also has a sampling and integrating phase as will be described below.

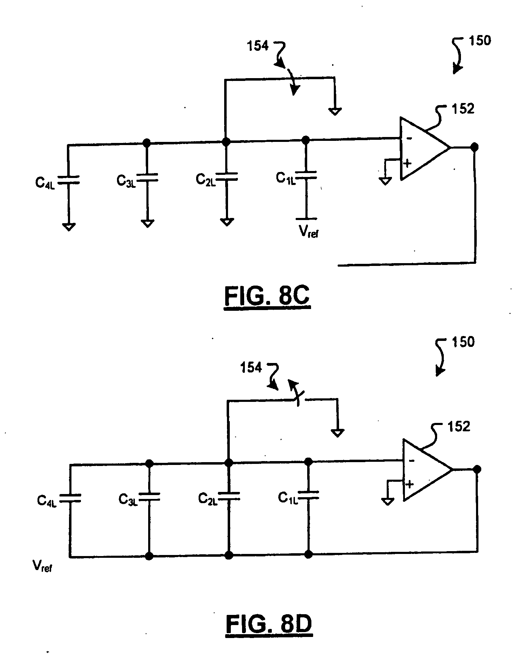

Referring now to FIGs. 8C and 8D, an equivalent circuit of the D/A converter of FIG. 8B during a sampling phase is shown for ${V}_{CDAC} = \frac{{V}_{ref}}{4} .$ During sampling phase, the switch 154 is closed and the capacitors C_{4L}, C_{3L} and C_{2L} are connected to a reference potential such as ground. The capacitor C_{1L} is charged to V_{ref}. A charge is accumulated on the capacitor C_{1L} that is equal to *V_{ref}C*_{1*L*}.

During the integrating phase, the switch 154 is opened and the capacitors C_{4L}, C_{3L}, C_{2L} and C_{1L} are connected in feedback. The total charge before the switch 154 is opened is the same as the total charge after the switch 154 is opened. Therefore: ${Q}_{T} = {VC}_{T} = {V}_{ref} {C}_{1 L} = V \left({C}_{1 L}+{C}_{2 L}+{C}_{3 L}+{C}_{4 L}\right) ;$ $V = {V}_{ref} \frac{{C}_{1 L}}{{C}_{1 L} + {C}_{2 L} + {C}_{3 L} + {C}_{4 L}} .$ Assuming that C_{1L}, C_{2L}, C_{3L} and C_{4L} are equal, $V = \frac{{V}_{ref}}{4} .$

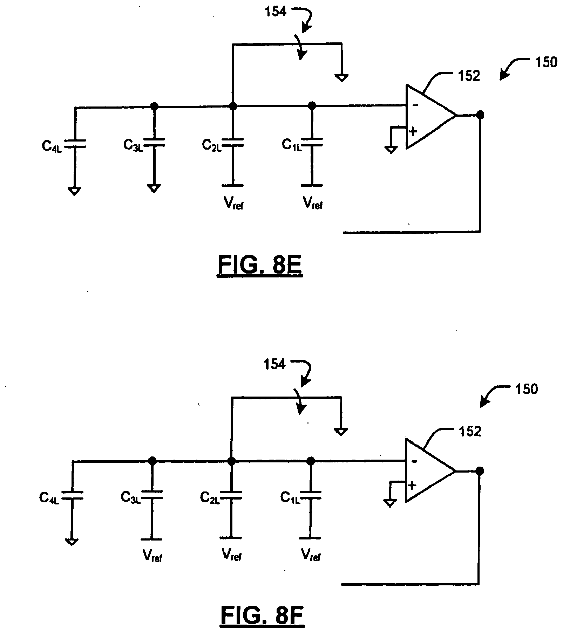

Referring now to FIG. 8E, an equivalent circuit of the D/A converter of FIG. 8B during a sampling phase is shown for ${V}_{CDAC} = \frac{{V}_{ref}}{2} .$ During sampling phase, the switch 154 is closed and the capacitors C_{4L} and C_{3L} are connected to a reference potential such as ground. The capacitors C_{1L} and C_{2L} are charged to V_{ref}. A charge Is accumulated on the capacitors C_{1L} and C_{2L} that is equal to *V_{ref}*(*C*_{1*L*} + *C*_{2*L*}).

During the integrating phase, the switch 154 is opened and the capacitors C_{4L}, C_{3L}, C_{2L} and C_{1L} are connected in feedback. The total charge before the switch 154 is opened is the same as the total charge after the switch 154 is opened. Therefore: ${Q}_{T} = {VC}_{T} = {V}_{ref} \left({C}_{1 L}+{C}_{2 L}\right) = V \left({C}_{1 L}+{C}_{2 L}+{C}_{3 L}+{C}_{4 L}\right) ;$ $V = {V}_{ref} \frac{{C}_{1 L} + {C}_{2 L}}{\left({C}_{1 L}+{C}_{2 L}+{C}_{3 L}+{C}_{4 L}\right)} .$ Assuming that C₁, C₂, C₃ and C₄ are equal, $V = \frac{{V}_{ref}}{2} .$

Referring now to FIG. 8F, an equivalent circuit of the D/A converter of FIG. 8B during a sampling phase is shown for ${V}_{CDAC} = \frac{3 {V}_{ref}}{4} .$ During sampling phase, the switch 154 is closed and the capacitor C_{4L} is connected to a reference potential such as ground. The capacitors C_{1L}, C_{2L} and C_{3L} are charged to V_{ref}. A charge Is accumulated on the capacitors C_{1L}, C_{2L} and C_{3L} that is equal to *V_{ref}*(C_{1*L*} + C_{2*L*} + C_{3*L*}).

During the integrating phase, the switch 154 is opened and the capacitors C_{4L}, C_{3L}, C_{2L} and C_{1L} are connected in feedback. The total charge before the switch 154 is opened is the same as the total charge after the switch 154 is opened. Therefore: ${Q}_{r} = {VC}_{r} = {V}_{ref} \left({C}_{1 L}+{C}_{2 L}+{C}_{3 L}\right) = V \left({C}_{1 L}+{C}_{2 L}+{C}_{3 L}+{C}_{4 L}\right) ;$ $V = {V}_{ref} \frac{{C}_{1 L} + {C}_{2 L} + {C}_{3 L}}{\left({C}_{1 L}+{C}_{2 L}+{C}_{3 L}+{C}_{4 L}\right)} .$ Assuming that C_{1L}, C_{2L}, C_{3L} and C_{4L} are equal, $V = \frac{3 {V}_{ref}}{4} .$

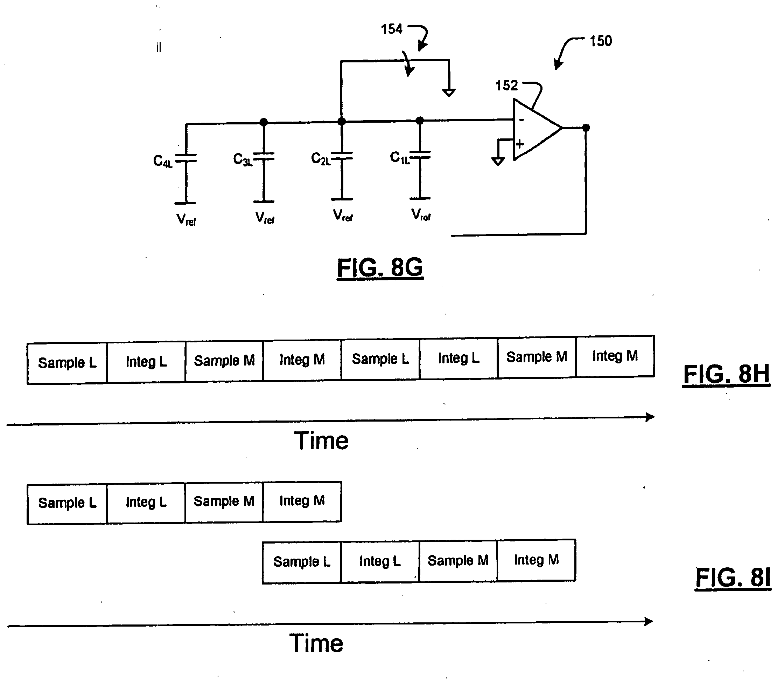

Referring now to FIG. 8G, an equivalent circuit of the D/A converter of FIG. 8B during a sampling phase Is shown for *V_{CDAC}*=*V_{ref}.* The switch associated with this position may be omitted since this value can be already be obtained by using the next MSB. In this case one of the capacitors may always be connected to ground. If a switch is used, during sampling phase the switch 154 is closed and the capacitors C_{1L}, C_{2L}, C_{3L} and C_{4L} are charged to V_{ref}. A charge is accumulated on the capacitors C_{1L}, C_{2L}, C_{3L} and C_{4L} that is equal to *V_{ref}*(C_{1*L*} + C_{2*L*} + C_{3*L*} + C_{4*L*}).

During the integrating phase, the switch 154 is opened and the capacitors C_{4L}, C_{3L}, C_{2L} and C_{1L} are connected in feedback. The total charge before the switch 154 is opened is the same as the total charge after the switch 154 is opened. Therefore: ${Q}_{r} = {VC}_{r} = {V}_{ref} \left({C}_{1 L}+{C}_{2 L}+{C}_{3 L}+{C}_{4 L}\right) = V \left({C}_{1 L}+{C}_{2 L}+{C}_{3 L}+{C}_{4 L}\right) ;$ $V = {V}_{ref} \frac{{C}_{1 L} + {C}_{2 L} + {C}_{3 L} + {C}_{4 L}}{\left({C}_{1 L}+{C}_{2 L}+{C}_{3 L}+{C}_{4 L}\right)} .$

Assuming that C_{1L}, C_{2L,} C_{3L} and C_{4L} are equal, *V* = *V_{ref}*.

Referring now to FIGs. 8H and 8I, non-overlapping and overlapping timing diagrams are shown for sampling and integrating phases for LSB and MSB capacitive portions. The timing of the sampling and integrating phases can be non-overlapping as shown in FIG. 8H. Alternately, the sampling phase of the LSB capacitive portion can fully and/or partially overlap the integrating phase of the MSB capacitive portion as shown in FIG. 8I.

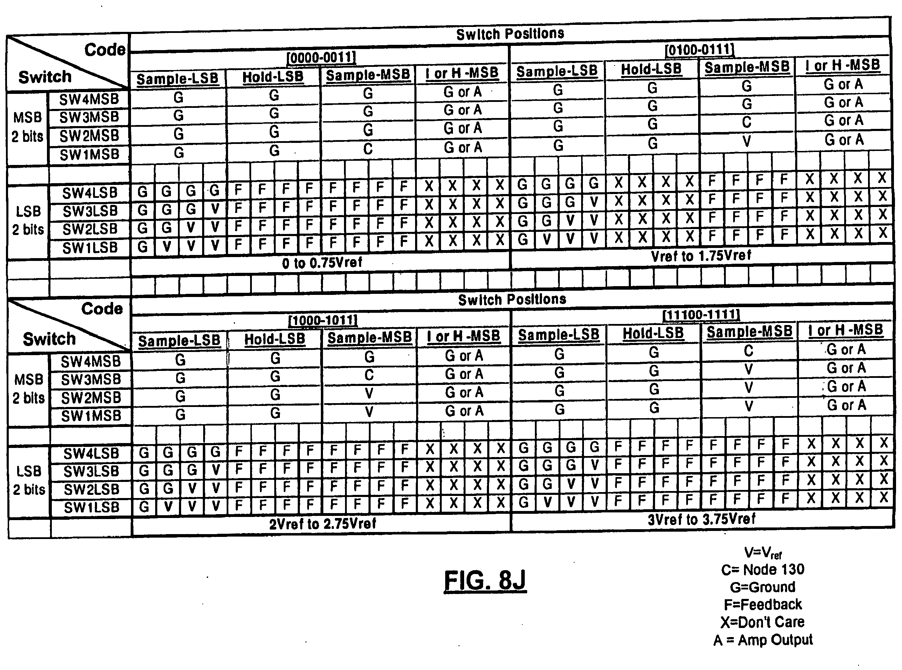

Referring now to FIG. 8J, a truth table for the D/A converter is shown. As can be appreciated, the LSB switches can be connected in feedback and/or to ground during the MSB-integrating phase and/or can begin the next LSB sampling phase as described herein.

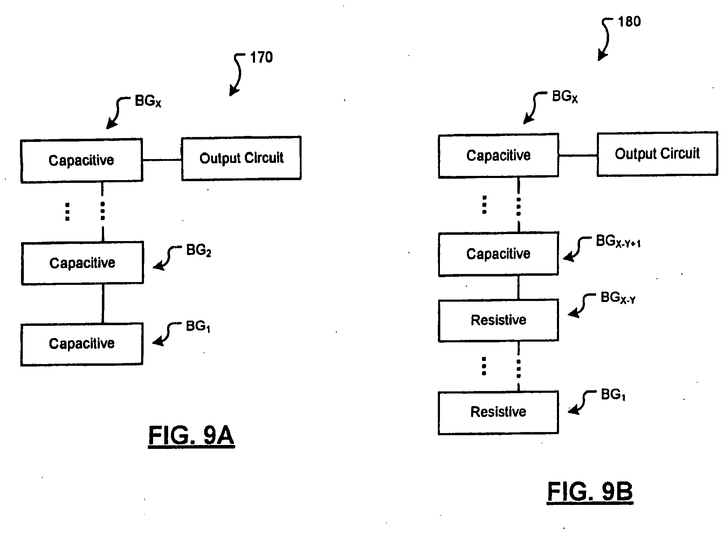

Referring now to FIG. 9A-9D, additional capacitive and/or resistive DAC portions may be added. In FIG. 9A, an N stage capacitive D/A converter 170 is shown. The converter 170 includes capacitive portions BG₁, BG₂, ..., and BGₓ, which are associated with LSB, next LSB, ..., and MSB groups. For example, a 6 bit example can include capacitive portions BG₁, BG₂ and BG₃. Each capacitive portion may include four capacitors as shown and described above. Each of the capacitive portions includes sampling and integrating stages that may be non-overlapping and/or overlapping as described above and below.

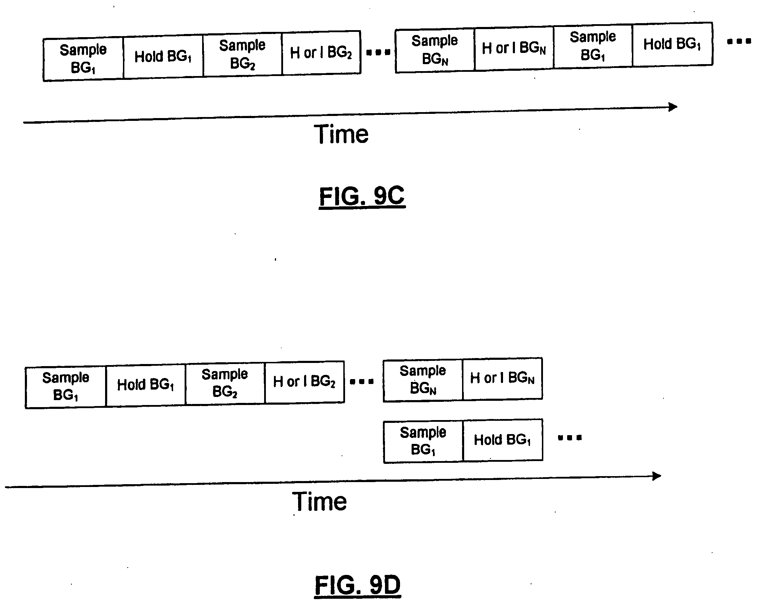

In FIG. 9B, an N stage capacitive-resistive D/A converter 180 is shown. One or more of the last stages is a resistive portion as described above. In this example, there are X-Y capacitive portions and Y resistive portions, where X and Y are integers greater than zero. When resistive portions are used, the sampling and integrating phases for the last capacitive stage and the final resistive stage can be the same as described above. In FIG. 9C, an exemplary timing diagram shows non-overlapping sampling and integrating phases for additional capacitive stages. In FIG. 9D, an exemplary timing diagram showing fully and/or partially overlapping sampling and integrating phases for additional capacitive stages is shown.

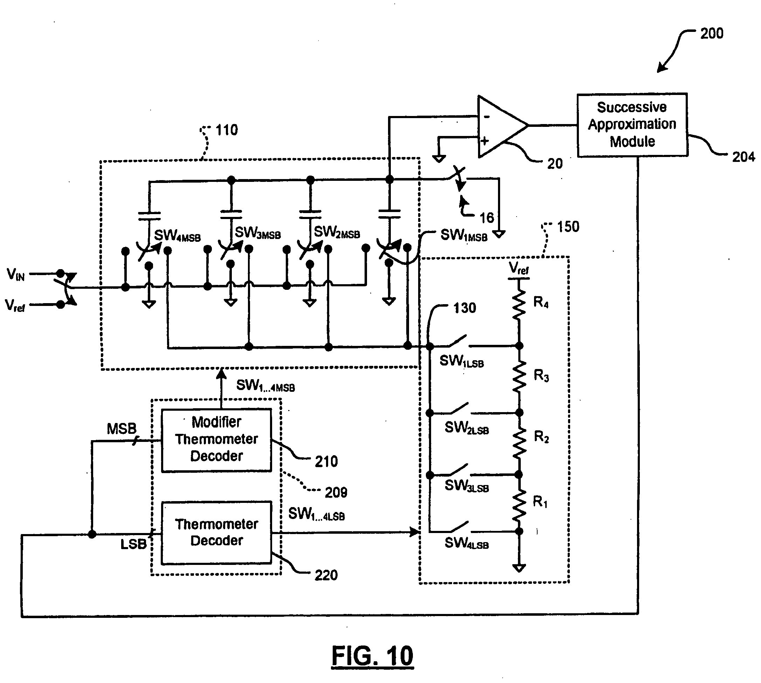

Referring now to FIG. 10, a successive approximation A/D converter 200 is shown. The converter 200 includes a successive approximation register (SAR) 204 or module that contains logic for resolving the digital bits as will be described further below. An output of the SAR 204 is input to decoder module 209 that may include a modified thermometer decoder 210 that communicates with and controls switches SW_{4MSB}, SW_{3MSB}, SW_{2MSB}, and SW_{1MSB} (collectivelyswitches SW_{M}) based on MSBs of the output of the SAR. An output of the SAR 204 is input to a thermometer decoder 220 that communicates with and controls switches SW_{4LSB}. SW_{3LSB}, SW_{2LSB}, and SW_{1LSB} based on LSBs in the output of the SAR 204.

During acquisition, the switch 16 is connected to ground. Ends of the capacitors are connected by switches SW_{M} to Vᵢₙ. After acquisition of Vᵢₙ. the switch 16 is opened and the capacitors are disconnected by switches SW_{M} from Vᵢₙ. The capacitor array is charged with a voltage based on Vᵢₙ. The capacitors are then connected to ground by switches SW_{M} which drives the common terminal negative to a voltage equal to -Vᵢₙ.

As the first step in a binary search algorithm, the capacitive and resistive portions are configured to provide 1/2V_{ref} as described above. In other words, C_{4M} is connected to the common node, C_{3M}, C_{2M} and C_{1M} are connected to V_{ref} and the switch SW_{1LSB} is closed. For example, if Vᵢₙ is equal to 3/4V_{ref}, the common terminal will be driven to (-3/4V_{ref} + 1/2V_{ref}) = - 1/4V_{ref}. When this voltage is compared to ground, the output of the comparator 20 yields a logic '1', implying that Vᵢₙ is greater than 1/2V_{ref}. If Vᵢₙ is equal to 1/4_{ref}, the common terminal voltage is (-1/4V_{ref} + 1/2V_{ref}) = +1/4V_{ref}, and the output of the comparator 20 is a logic '0'. This process continues with the next MSB or LSB depending upon the value of the comparator output until all bits are resolved. While capacitive-resistive implementation is shown, capacitive-capacitive, N-stage capacitive or N-stage capacitive-resistive implementations are also contemplated.

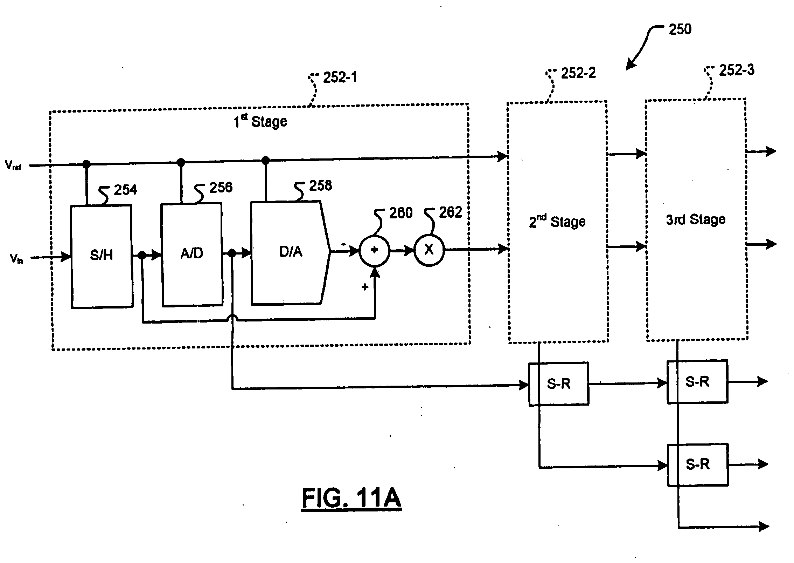

Referring now to FIG. 11A, a pipelined A/D converter 250 is shown. The converter 250 includes a plurality of stages 252-1, 252-2, 252-3 (collectively 252) that are cascaded in series. Each of the course A/D converter stages 252 includes a sample and hold module 254 that samples and holds the analog output signal from a prior stage, a low resolution A/D subconverter module 256 that converts the held analog signal, a low-resolution D/A subconverter module 258 that converts the resulting digital output back into an analog representation, a difference module 260 and an analog interstage difference amplifier module 262 that amplifies the residue. The residue is the difference between the held analog signal and the reconstructed analog signal.

The first stage 252-1 of the pipelined A/D converter 250 operates on a most current analog input sample while the second stage 252-2 operates on the amplified residue of the previous input sample. The concurrency of operations results in a conversion speed that is determined only by the time it takes in one stage.

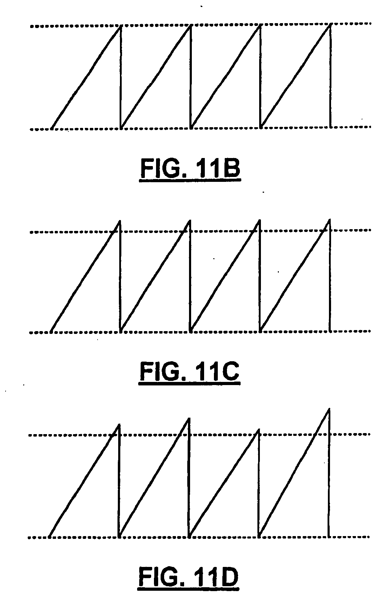

Referring now to FIG. 11B-11D, ideal and non-ideal residue voltages are shown. In FIG. 11B, an ideal residue voltage is shown. When the input reaches a first decision level of the A/D subconverter module 252, the output of the subconverter module switches to its next higher level code causing the output of the D/A subconverter to switch to its next higher level. This in turn causes the amplified residue to drop back to zero.

In actual implementations, however, the components are not ideal and non-uniformity occurs. In FIG. 11C, the residue voltage exceeds the ideal value by a fixed amount. In FIG. 11D, the residue voltage exceeds the ideal residue voltage by a variable amount.

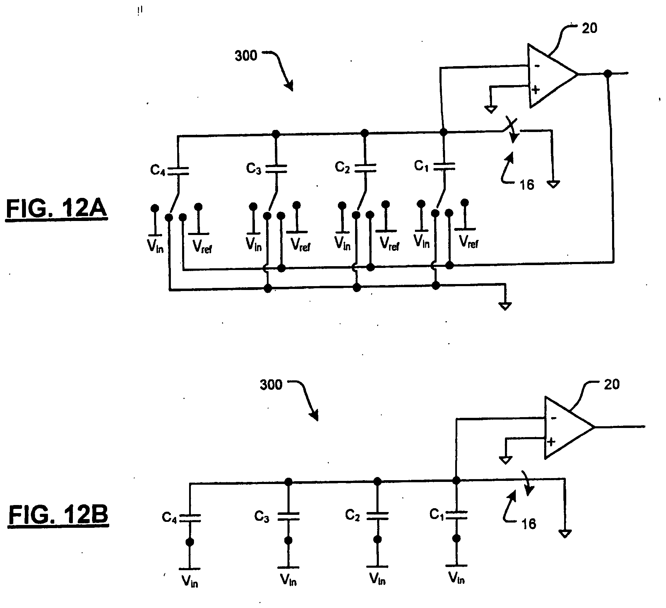

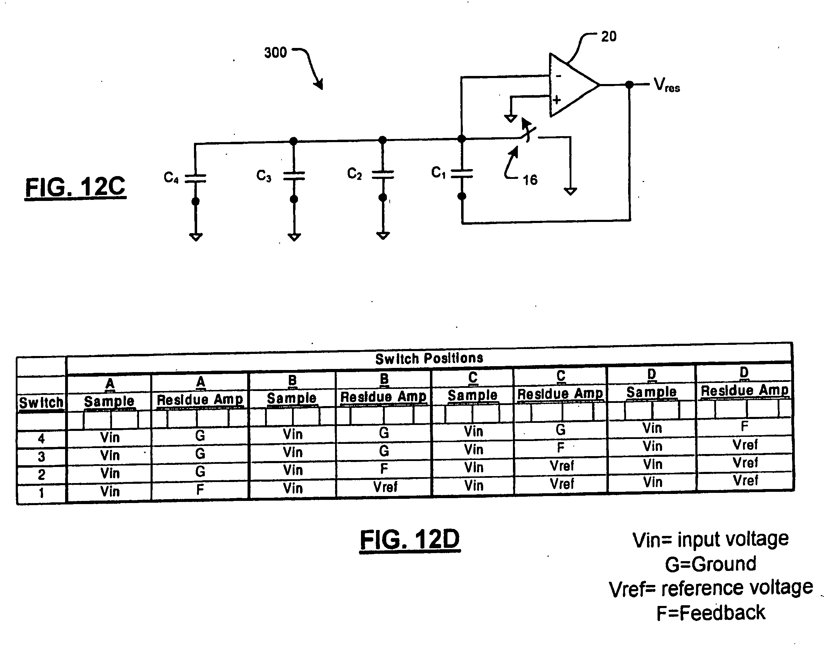

Referring now to FIG. 12A, an analog to digital converter 300 that generates a residue voltage with lower variation according to the present invention is shown. Capacitors C₁, C₂, C₃ and C₄ are selectively connected to Vᵢₙ, a reference potential such as ground, a voltage reference (V_{ref}) and to an output of the opamp 20. In some implementations, C₁, C₂, C₃ and C₄ have substantially equal capacitance values.

Referring now to FIGs. 12B-12D, the analog to digital converter of FIG. 12A is shown further. In a sampling phase in FIG. 12B, the switch 16 is closed and the capacitors are connected to Vᵢₙ. In a residue amplification stage in FIG. 12B for Vₗₙ between 0 and $\frac{{C}_{1}}{{C}_{1} + {C}_{2} + {C}_{3} + {C}_{4}} {V}_{ref}$ ("A" in FIG. 12D), the switch 16 is opened, the capacitor C₁ is connected in feedback arrangement. The capacitors C₂, C₃, and C₄ are connected to the reference potential. A truth table is shown in FIG. 12D.

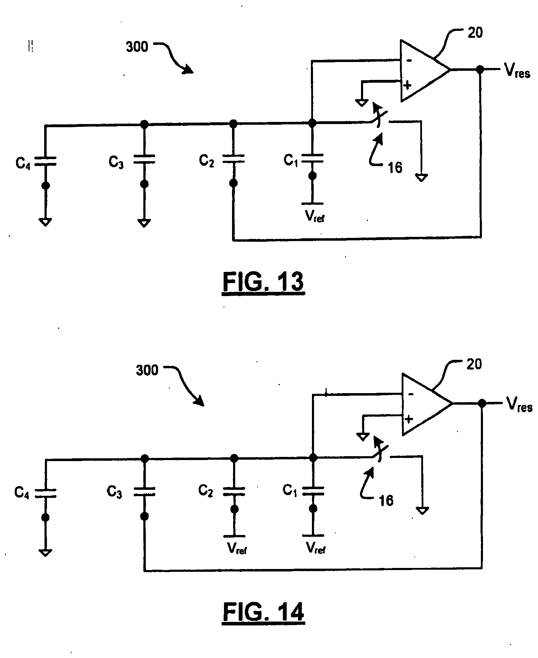

Referring now to FIG. 13, in a residue amplification stage for Vᵢₙ between $\frac{{C}_{1}}{{C}_{1} + {C}_{2} + {C}_{3} + {C}_{4}} {V}_{ref}$ and $\frac{{C}_{1} + {C}_{2}}{{C}_{1} + {C}_{2} + {C}_{3} + {C}_{4}} {V}_{ref}$ ("B" in FIG. 12D), the switch 16 is opened, the capacitor C₂ is connected in feedback arrangement and the capacitor C₁ is connected to V_{ref}. The capacitors C₃ and C₄ are connected to a reference potential.

Referring now to FIG. 14, in a residue amplification stage for Vᵢₙ between $\frac{{C}_{1} + {C}_{2}}{{C}_{1} + {C}_{2} + {C}_{3} + {C}_{4}} {V}_{ref}$ and $\frac{{C}_{1} + {C}_{2} + {C}_{3}}{{C}_{1} + {C}_{2} + {C}_{3} + {C}_{4}} {V}_{ref}$ ("C" in FIG. 12D), the switch 16 is opened, the capacitor C₃ is connected in feedback arrangement and the capacitors C₁ and C₂ are connected to V_{ref}. The capacitor C₄ is connected to a reference potential.

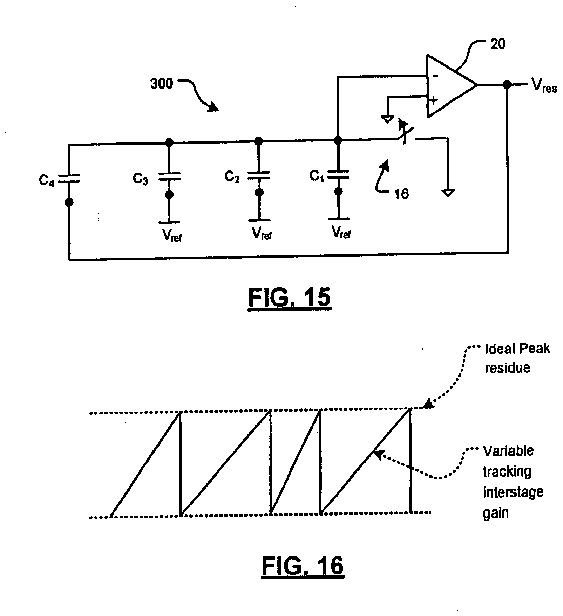

Referring now to FIGs. 15 and 16, in a residue amplification stage for Vᵢₙ between $\frac{{C}_{1} + {C}_{2} + {C}_{3}}{{C}_{1} + {C}_{2} + {C}_{3} + {C}_{4}} {V}_{ref}$ and *V_{ref}* ("D" in FIG. 12D), the switch 16 is opened, the capacitor C₄ is connected in feedback arrangement and the capacitors C₁, C₂ and C₃ are connected to V_{ref}. Note that because the different capacitors are used as the feedback capacitor during residue amplification, the residue gain can perfectly track the capacitor mismatch. The residue voltage now looks as shown in FIG. 16. There is a variable inter-stage gain and a substantially constant maximum residue voltage.

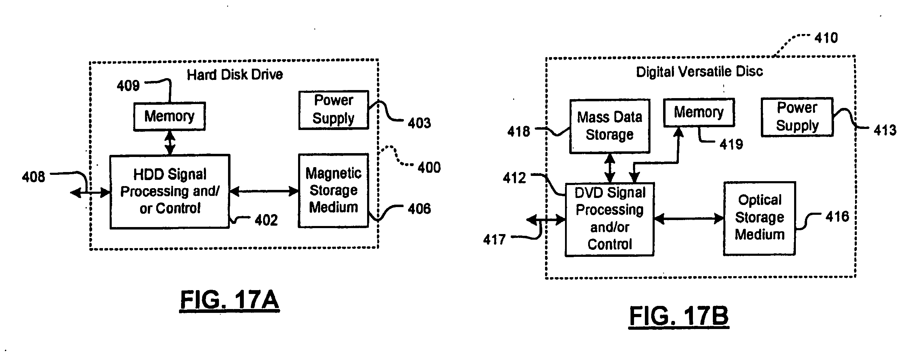

Referring now to FIGs. 17A-17G, various exemplary implementations of the present invention are shown. Referring now to FIG. 17A, the present invention can be implemented in D/A or A/D converters in a hard disk drive 400. In some implementations, the signal processing and/or control circuit 402 and/or other circuits (not shown) in the HDD 400 may process data, perform coding and/or encryption, perform calculations, and/or format data that is output to and/or received from a magnetic storage medium 406.

The HDD 400 may communicate with a host device (not shown) such as a computer, mobile computing devices such as personal digital assistants, cellular phones, media or MP3 players and the like, and/or other devices via one or more wired or wireless communication links 408. The HDD 400 may be connected to memory 409 such as random access memory (RAM), low latency nonvolatile memory such as flash memory, read only memory (ROM) and/or other suitable electronic data storage.

Referring now to FIG. 17B, the present invention can be implemented in D/A or A/D converters in a digital versatile disc (DVD) drive 410. The signal processing and/or control circuit 412 and/or other circuits (not shown) in the DVD 410 may process data, perform coding and/or encryption, perform calculations, and/or format data that is read from and/or data written to an optical storage medium 416. In some implementations, the signal processing and/or control circuit 412 and/or other circuits (not shown) in the DVD 410 can also perform other functions such as encoding and/or decoding and/or any other signal processing functions associated with a DVD drive.

The DVD drive 410 may communicate with an output device (not shown) such as a computer, television or other device via one or more wired or wireless communication links 417. The DVD 410 may communicate with mass data storage 418 that stores data in a nonvolatile manner. The mass data storage 418 may include a hard disk drive (HDD). The HDD may have the configuration shown in FIG. 17A. The HDD may be a mini HDD that includes one or more platters having a diameter that is smaller than approximately 1.8". The DVD 410 may be connected to memory 419 such as RAM, ROM, low latency nonvolatile memory such as flash memory and/or other suitable electronic data storage.

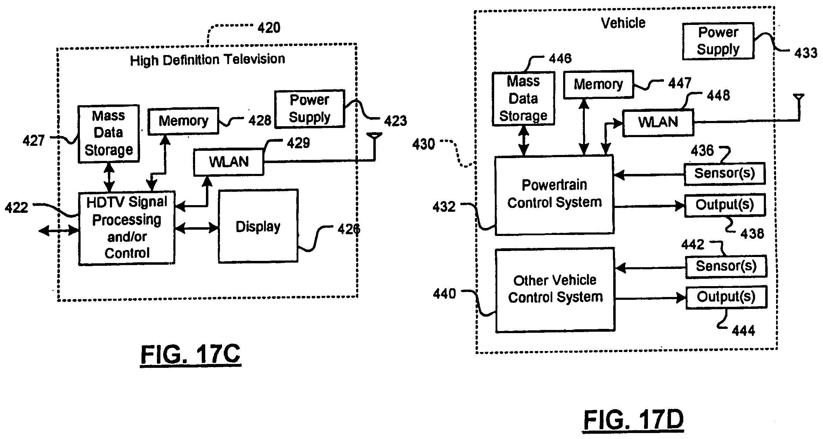

Referring now to FIG. 17C, the present invention can be implemented in D/A or A/D converters in a high definition television (HDTV) 420. The HDTV 420 receives HDTV input signals in either a wired or wireless format and generates HDTV output signals for a display 426. In some implementations, signal processing circuit and/or control circuit 422 and/or other circuits (not shown) of the HDTV 420 may process data, perform coding and/or encryption, perform calculations, format data and/or perform any other type of HDTV processing that may be required.

The HDTV 420 may communicate with mass data storage 427 that stores data in a nonvolatile manner such as optical and/or magnetic storage devices. At least one HDD may have the configuration shown in FIG. 17A and/or at least one DVD may have the configuration shown in FIG. 17B. The HDD may be a mini HDD that includes one or more platters having a diameter that is smaller than approximately 1.8". The HDTV 420 may be connected to memory 428 such as RAM, ROM, low latency nonvolatile memory such as flash memory and/or other suitable electronic data storage. The HDTV 420 also may support connections with a WLAN via a WLAN network interface 429.

Referring now to FIG. 17D, the present invention may implement and/or be implemented in D/A or A/D converters in a control system of a vehicle 430, a WLAN interface, mass data storage of the vehicle control system and/or a power supply 433. In some implementations, the present invention implement a powertrain control system 432 that receives inputs from one or more sensors such as temperature sensors, pressure sensors, rotational sensors, airflow sensors and/or any other suitable sensors and/or that generates one or more output control signals such as engine operating parameters, transmission operating parameters, and/or other control signals.

The present invention may also be implemented in other control systems 440 of the vehicle 430. The control system 440 may likewise receive signals from input sensors 442 and/or output control signals to one or more output devices 444. In some implementations, the control system 440 may be part of an anti-lock braking system (ABS), a navigation system, a telematics system, a vehicle telematics system, a lane departure system, an adaptive cruise control system, a vehicle entertainment system such as a stereo, DVD, compact disc and the like. Still other implementations are contemplated.

The powertrain control system 432 may communicate with mass data storage 446 that stores data in a nonvolatile manner. The mass data storage 446 may include optical and/or magnetic storage devices for example hard disk drives HDD and/or DVDs. At least one HDD may have the configuration shown in FIG. 17A and/or at least one DVD may have the configuration shown in FIG. 17B. The HDD may be a mini HDD that includes one or more platters having a diameter that is smaller than approximately 1.8". The powertrain control system 432 may be connected to memory 447 such as RAM, ROM, low latency nonvolatile memory such as flash memory and/or other suitable electronic data storage. The powertrain control system 432 also may support connections with a WLAN via a WLAN network interface 448. The control system 440 may also include mass data storage, memory and/or a WLAN interface (all not shown).

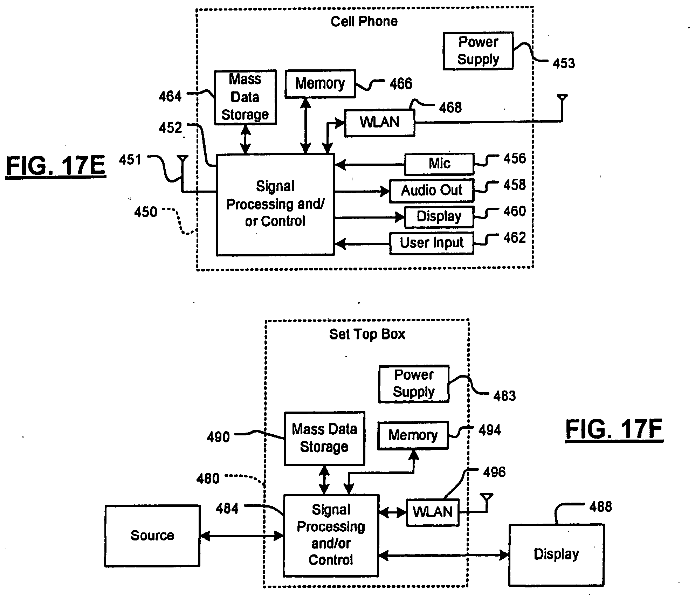

Referring now to FIG. 17E, the present invention can be implemented in D/A or A/D converters in a cellular phone 450 that may include a cellular antenna 451. In some implementations, the cellular phone 450 includes a microphone 456, an audio output 458 such as a speaker and/or audio output jack, a display 460 and/or an input device 462 such as a keypad, pointing device, voice actuation and/or other input device. The signal processing and/or control circuits 452 and/or other circuits (not shown) in the cellular phone 450 may process data, perform coding and/or encryption, perform calculations, format data and/or perform other cellular phone functions.

The cellular phone 450 may communicate with mass data storage 464 that stores data in a nonvolatile manner such as optical and/or magnetic storage devices for example hard disk drives HDD and/or DVDs. At least one HDD may have the configuration shown in FIG. 17A and/or at least one DVD may have the configuration shown in FIG. 17B. The HDD may be a mini HDD that includes one or more platters having a diameter that is smaller than approximately 1.8". The cellular phone 450 may be connected to memory 466 such as RAM, ROM, low latency nonvolatile memory such as flash memory and/or other suitable electronic data storage. The cellular phone 450 also may support connections with a WLAN via a WLAN network interface 468.

Referring now to FIG. 17F, the present invention can be implemented in D/A or A/D converters in a set top box 480. The set top box 480 receives signals from a source such as a broadband source and outputs standard and/or high definition audio/video signals suitable for a display 488 such as a television and/or monitor and/or other video and/or audio output devices. The signal processing and/or control circuits 484 and/or other circuits (not shown) of the set top box 480 may process data, perform coding and/or encryption, perform calculations, format data and/or perform any other set top box function.

The set top box 480 may communicate with mass data storage 490 that stores data in a nonvolatile manner. The mass data storage 490 may include optical and/or magnetic storage devices for example hard disk drives HDD and/or DVDs. At least one HDD may have the configuration shown in FIG. 17A and/or at least one DVD may have the configuration shown in FIG. 17B. The HDD may be a mini HDD that includes one or more platters having a diameter that is smaller than approximately 1.8". The set top box 480 may be connected to memory 494 such as RAM, ROM, low latency nonvolatile memory such as flash memory and/or other suitable electronic data storage. The set top box 480 also may support connections with a WLAN via a WLAN network interface 496.

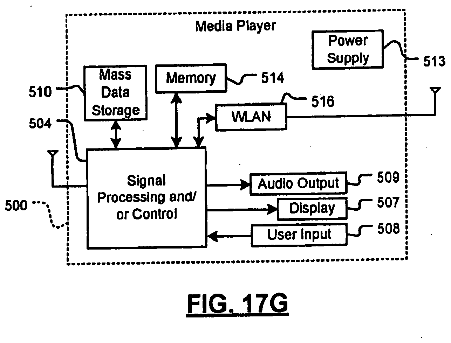

Referring now to FIG. 17G, the present invention can be implemented in D/A or A/D converters in a media player 500. In some implementations, the media player 500 includes a display 507 and/or a user input 508 such as a keypad, touchpad and the like. In some implementations, the media player 500 may employ a graphical user interface (GUI) that typically employs menus, drop down menus, icons and/or a point-and-click interface via the display 507 and/or user input 508. The media player 500 further includes an audio output 509 such as a speaker and/or audio output jack. The signal processing and/or control circuits 504 and/or other circuits (not shown) of the media player 500 may process data, perform coding and/or encryption, perform calculations, format data and/or perform any other media player function.

The media player 500 may communicate with mass data storage 510 that stores data such as compressed audio and/or video content in a nonvolatile manner. In some implementations, the compressed audio files include files that are compliant with MP3 format or other suitable compressed audio and/or video formats. The mass data storage may include optical and/or magnetic storage devices for example hard disk drives HDD and/or DVDs. At least one HDD may have the configuration shown in FIG. 17A and/or at least one DVD may have the configuration shown in FIG. 17B. The HDD may be a mini HDD that includes one or more platters having a diameter that is smaller than approximately 1.8". The media player 500 may be connected to memory 514 such as RAM, ROM, low latency nonvolatile memory such as flash memory and/or other suitable electronic data storage. The media player 500 also may support connections with a WLAN via a WLAN network interface 516. Still other implementations in addition to those described above are contemplated.

## Claims

1. A X-stage digital-to-analog converter, DAC (100-1) for converting an N bit digital value to an analog signal, with N,X being integers greater than one, said X-stage DAC comprising:
a first capacitive DAC stage (110) that comprises:
M first capacitances (C₄, C₃, C₂, C₁) that are connected in parallel and that have first ends and second ends, with M being an integer greater than one; and
M first switches (SW_{MSB}) that first, during a sampling phase, connect a selected one of said second ends of said N first capacitances (C₄, C₃, C₂, C₁) to a common node (130) at a same time that remaining ones of said second ends of said M first capacitances (C₄, C₃, C₂, C₁) are connected to one of a voltage reference and a ground, and that second, during an integrating phase subsequent to said sampling phase, connect said selected one of said second ends of said M first capacitances to said ground at a same time that said remaining ones of said second ends of said M first capacitances are connected to said ground;
a first amplifier (20) having an input and an output,
wherein capacitance values of said M first capacitances (C₄, C₃, C₂, C₁) are substantially equal; and wherein said first ends are connected to said input of said amplifier (20) and disconnected from said ground during said integrating phase, and wherein said first ends are connected to said ground and disconnected from said input of said first amplifier (20) during said sampling phase; and
a second capacitive DAC stage (150) comprising M second switches (SW_{LSB}) and a second amplifier (152), wherein the second amplifier having the output connected to the common node of the first stage,
wherein the N/X MSB bits of the N bit digital value are allocated to the M first switches (SW_{MSB}) of the first DAC stage and each respective N/X bits of the N bit digital value are allocated to M switches of each respective further stage, and the N/X LSB bits of the N bit digital value are allocated to the M switches (SW_{LSB}) of the last DAC tage,
a control module (132) for controlling said switches (SW_{MSB}, SW_{LSB}) of said X stages,
and wherein second ends of capacitances of said second capacitive DAC stage are connected in feedback to the output of the second amplifier (152) during the sampling phase of the first capacitive DAC stage.

2. The X-stage digital-to-analog converter, DAC (100-1) of claim 1 further comprising:
a feedback capacitance (C_{f}) that is connected to said input and said output of said first amplifier (20).

3. The X-stage digital-to-analog converter, DAC (100-1) of claim 1, wherein the X-stage digital-to-analog converter, DAC (100-1) comprises at least one or more further DAC (120, 150) stages connected to said common node (130), wherein the at least one or more further DAC stage is one of
a capacitive DAC (150) stage comprising M respective switches (SW_{LSB}) and a respective amplifier, wherein the output of the respective amplifier is connected to a common node of the previous stage, OR
a resistive DAC (120) stage comprising M respective resistances (R₄, R₃, R₂, R₁) connected in series between said voltage reference and said ground, M respective nodes between said M respective resistances and said ground, and M respective switches (SW_{LSB}) that selectively connect said M respective nodes to a common node of the previous stage.

## Patentansprüche

1. X-stufiger Digital-Analog-Wandler, DAC (100-1) zur Umwandlung eines N Bit-Digitalwertes in ein analoges Signal, wobei: N, X ganze Zahlen von größer Eins sind, und wobei der X-stufige DAC nachstehendes umfasst:
eine erste kapazitive DAC-Stufe (110), umfassend:
M erste Kapazitäten (C₄, C₃, C₂, C₁), die parallel zueinander verbunden sind und erste Enden und zweite Enden aufweisen, wobei M eine ganze Zahl von größer Eins ist; und
M erste Schalter (SW_{MSB}), die zuerst, während einer Abtastphase, ein ausgewähltes Ende der zweiten Enden der N ersten Kapazitäten (C₄, C₃, C₂, C₁) mit einem gemeinsamen Knoten (130) verbinden, zur gleichen Zeit, zu der die verbliebenen Enden der zweiten Enden der M ersten Kapazitäten (C₄, C₃, C₂, C₁) mit einer Referenzspannungsquelle oder einer Erdung verbunden sind, und die als zweites, während einer Integrationsphase, die sich an die Abtastphase anschließt, das ausgewählte eine Ende der zweiten Enden der M ersten Kapazitäten mit der Erdung verbinden, zur gleichen Zeit, zu der die verbliebenen Enden der zweiten Enden der M ersten Kapazitäten mit der Erdung verbunden sind;
einen ersten Verstärker (20) mit einem Eingang und einem Ausgang,
wobei die Kapazitätswerte der M ersten Kapazitäten (C₄, C₃, C₂, C₁) im wesentlichen gleich sind; und wobei während der Integrationsphase die ersten Enden mit dem Eingang des Verstärkers (20) verbunden und von der Erdung getrennt sind, und wobei während der Abtastphase die ersten Enden mit der Erdung verbunden und von dem Eingang des ersten Verstärkers (20) getrennt sind; und
eine zweite kapazitive DAC-Stufe (150), die M zweite Schalter (SW_{LSB}) und einen zweiten Verstärker (152) umfasst, wobei der Ausgang des zweiten Verstärkers mit dem gemeinsamen Knoten der ersten Stufe verbunden ist,
wobei die N/X MSB-Bits des N Bit-Digitalwertes den M ersten Schaltern (SW_{MSB}) der ersten DAC-Stufe zugeordnet sind, und jedes entsprechende N/X-Bits des N Bit-Digitalwertes M Schaltern einer jeden entsprechenden weiteren Stufe zugeordnet sind, und N/X LSB-Bits des N Bit-Digitalwertes den M Schaltern (SW_{LSB}) der letzten DAC-Stufe zugeordnet sind,
ein Steuermodul (132) zur Steuerung der Schalter (SW_{MSB}, SW_{LSB}) der X Stufen,
und wobei zweite Enden der Kapazitäten der zweiten kapazitiven DAC-Stufe in Rückkopplung mit dem Ausgang des zweiten Verstärkers (152) während der Abtastphase der ersten kapazitiven DAC-Stufe verbunden sind.

2. X-stufiger Digital-Analog-Wandler, DAC (100-1) nach Anspruch 1, des Weiteren umfassend:
eine Rückkopplungskapazität (C_{f}), die mit dem Eingang und dem Ausgang des ersten Verstärkers (20) verbunden ist.

3. X-stufiger Digital-Analog-Wandler, DAC (100-1) nach Anspruch 1, wobei der X -stufige Digital-Analog-Wandler, DAC (100-1) mindestens eine oder mehrere weitere DAC-Stufen (120, 150) umfasst, die mit dem gemeinsamen Knoten (130) verbunden sind, wobei die mindestens eine oder mehrere weitere DAC-Stufe umfasst:
eine kapazitive DAC-Stufe (150), die M entsprechende Schalter (SW_{LSB}) und einen entsprechenden Verstärker umfasst, wobei der Ausgang des entsprechenden Verstärkers mit einem gemeinsamen Knoten der vorherigen Stufe verbunden ist, ODER
eine resistive DAC-Stufe (120), die M entsprechende Widerstände (R₄, R₃, R₂, R₁), die in Reihe zwischen der Referenzspannungsquelle und der Erdung verbunden sind, M entsprechende Knoten zwischen den M entsprechenden Widerständen und der Erdung, und M entsprechende Schalter (SW_{LSB}) umfasst, die selektiv die M entsprechenden Knoten mit einem gemeinsamen Knoten der vorherigen Stufe verbinden.

## Revendications

1. Convertisseur numérique-analogique à X niveaux, DAC (100-1), pour convertir une valeur numérique N bit en un signal analogique, N et X étant des nombres entiers plus grands que un, ledit DAC à X niveaux comprenant :
un premier niveau DAC capacitif (110) qui comprend :
M premières capacitances (C₄, C₃, C₂, C₁) qui sont connectées en parallèle et qui possèdent des premières extrémités et des secondes extrémités, M étant un nombre entier plus grand que un ; et
M premiers commutateurs (SW_{MSB}) qui dans un premier temps, lors d'une phase d'échantillonnage, connectent une extrémité sélectionnée parmi lesdites secondes extrémités desdites N premières capacitances (C₄, C₃, C₂, C₁) à un noeud commun (130) en un même temps que les extrémités restantes desdites secondes extrémités desdites M premières capacitances (C₄, C₃, C₂, C₁) sont connectées à une tension de référence ou à une masse, et qui dans un second temps, lors d'une phase d'intégration suivant ladite phase d'échantillonnage, connectent ladite extrémité sélectionnée parmi lesdites secondes extrémités desdites M premières capacitances à ladite masse en un même temps que lesdites extrémités restantes desdites secondes extrémités desdites M premières capacitances sont connectées à ladite masse ;
un premier amplificateur (20) comprenant une entrée et une sortie,
où des valeurs de capacitance desdites M premières capacitances (C₄, C₃, C₂, C₁) sont substantiellement égales ; et où lesdites premières extrémités sont connectées à ladite entrée dudit amplificateur (20) et déconnectées de ladite masse lors de ladite phase d'intégration, et où lesdites premières extrémités sont connectées à ladite masse et déconnectées de ladite entrée dudit premier amplificateur (20) lors de ladite phase d'échantillonnage ; et
un second niveau DAC capacitif (150) comprenant M seconds commutateurs (SW_{LSS}) et un second amplificateur (152), où le second amplificateur comprenant une sortie connectée au noeud commun du premier niveau,
où les bits N/X MSB de la valeur numérique N bit sont alloués aux M premiers commutateurs (SW_{MSB}) du premier niveau DAC et chaque N/X bit respectif de la valeur numérique N bit est alloué aux M commutateurs de chaque niveau supplémentaire respectif, et les bits N/X LSB de la valeur numérique N bit sont alloués aux M commutateurs (SW_{LSB}) du dernier niveau DAC,
un module de commande (132) pour commander lesdits commutateurs (SW_{MSB}, SW_{LSB}) desdits X niveaux,
et où des secondes extrémités des capacitances dudit second niveau DAC capacitif sont connectées en retour à la sortie du second amplificateur (152) lors de la phase d'échantillonnage du premier niveau DAC capacitif.

2. Convertisseur numérique-analogique à X niveaux, DAC (100-1), selon la revendication 1 comprenant en outre :
une capacitance de retour (C_{f}) qui est connectée à ladite entrée et ladite sortie dudit premier amplificateur (20).

3. Convertisseur numérique-analogique à X niveaux, DAC (100-1), selon la revendication 1, où le convertisseur numérique-analogique à X niveaux, DAC (100-1), comprend au moins un ou plusieurs niveaux DAC supplémentaires (120, 150) connectés audit noeud commun (130), où l'au moins un ou plusieurs niveaux DAC supplémentaires est l'un des niveaux suivants :
un niveau DAC capacitif (150) comprenant M commutateurs respectifs (SW_{MSB}) et un amplificateur respectif, où la sortie de l'amplificateur respectif est connectée à un noeud commun du niveau précédent, OU
un niveau DAC résistif (120) comprenant M résistances respectives (R₄, R₃, R₂, R₁) connectées en série entre ladite tension de référence et ladite masse, M noeuds respectifs entre lesdites M résistances respectives et ladite masse, et M commutateurs respectifs (SW_{LSB}) qui connectent sélectivement lesdits M noeuds respectifs à un noeud commun du niveau précédent.
